(19) **Europäisches Patentamt**
**European Patent Office**
**Office européen des brevets**

(11) **EP 4 215 989 A1**

(12) **EUROPEAN PATENT APPLICATION**

(43) Date of publication:
26.07.2023 Bulletin 2023/30

(51) International Patent Classification (IPC):
*G03F 9/00* (2006.01)

(21) Application number: 22195331.8

(22) Date of filing: 13.09.2022

(52) Cooperative Patent Classification (CPC):
G03F 9/7003

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(30) Priority: 25.01.2022 JP 2022009549
04.08.2022 JP 2022124977

(71) Applicant: **Kioxia Corporation**
**Tokyo 108-0023 (JP)**

(72) Inventor: **Mizuta, Yoshio**
**Tokyo, 108-0023 (JP)**

(74) Representative: **Hoffmann Eitle**
**Patent- und Rechtsanwälte PartmbB**
**Arabellastraße 30**
**81925 München (DE)**

(54) **EXPOSURE APPARATUS AND METHOD FOR MANUFACTURING SEMICONDUCTOR DEVICE**

(57) An exposure apparatus according to an embodiment is configured to implement an exposure process for exposing a substrate to light. The exposure apparatus includes a stage, a storage device, and a controller. The stage is configured to hold the substrate. The storage device is configured to store a plurality of correction maps each having an alignment correction value that differs from each other. The controller is configured to control in the exposure process an exposure position relative to the substrate by selecting a correction map from the correction maps based on measurement results of a plurality of alignment marks arranged on the substrate or an amount of warpage of the substrate and moving the stage based on the selected correction map.

FIG. 1

EP 4 215 989 A1

## Description

FIELD

Embodiments described herein relate generally to an exposure apparatus and a method for manufacturing a semiconductor device.

BACKGROUND

A three-dimensional stacking technique for three-dimensionally stacking semiconductor circuit substrates is known.

BRIEF DESCRIPTION OF THE DRAWINGS

FIG. 1 is a schematic view providing an overview of a method for manufacturing a semiconductor device;
FIG. 2 is a schematic diagram illustrating examples of overlay deviation components that can occur in a semiconductor device manufacturing process;
FIG. 3 is a schematic diagram illustrating examples of arrangements of alignment marks used in the semiconductor device manufacturing process;
FIG. 4 is a table illustrating an example of the correction performance of overlay deviation components in a wafer surface of an exposure apparatus and a bonding apparatus that are used in the semiconductor device manufacturing process;
FIG. 5 is a block diagram illustrating an example of a configuration of a semiconductor manufacturing system according to a first embodiment;
FIG. 6 is a block diagram illustrating an example of a configuration of an exposure apparatus according to the first embodiment;
FIG. 7 is a block diagram illustrating an example of a configuration of a bonding apparatus according to the first embodiment;
FIG. 8 is a block diagram illustrating an example of a configuration of a server according to the first embodiment;
FIG. 9 is a flowchart illustrating an example of an exposure process of the exposure apparatus according to the first embodiment;
FIG. 10 is a schematic view providing an overview of a bonding process by the bonding apparatus according to the first embodiment;
FIG. 11 is a schematic diagram illustrating a specific example of a bonding sequence of the bonding apparatus according to the first embodiment;
FIG. 12 is a flowchart illustrating an example of a method for creating map correction values that are used by the exposure apparatus according to the first embodiment;
FIG. 13 is a flowchart illustrating an example of a process relating to alignment correction of a random component in the semiconductor manufacturing system according to the first embodiment;
FIG. 14 is a schematic diagram illustrating an example of a method for improving a bond overlay in a first comparative example;
FIG. 15 is a schematic diagram illustrating examples of a method for improving a bond overlay according to the first embodiment;
FIG. 16 is a diagram illustrating examples of the relationship between the wafer magnification and the polynomial regression coefficient pertaining to a bonded wafer that is manufactured by the semiconductor manufacturing system according to a second embodiment;
FIG. 17 is a flowchart illustrating an example of a method for creating an overlay correction formula that is used by the exposure apparatus according to the second embodiment;
FIG. 18 is a flowchart illustrating an example of a process relating to alignment correction of a random component in the semiconductor manufacturing system according to the second embodiment;
FIG. 19 is a schematic diagram for describing a Zernike polynomial;
FIG. 20 is a block diagram illustrating an example of a configuration of a memory device according to a third embodiment;
FIG. 21 is a circuit diagram illustrating an example of a circuit configuration of a memory cell array included in a memory device according to the third embodiment;
FIG. 22 is a perspective view illustrating an example of a structure of a memory device according to the third embodiment;
FIG. 23 is a plan view illustrating an example of a planar layout of a memory cell array included in a memory device according to the third embodiment;
FIG. 24 is a cross-sectional view illustrating an example of a cross-sectional structure of a memory cell array included in the memory device according to the third embodiment;
FIG. 25 is a cross-sectional view taken along line XXV-XXV in FIG. 24, illustrating an example of a cross-sectional structure of a memory pillar included in the memory device according to a third embodiment; and
FIG. 26 is a cross-sectional view illustrating an example of a cross-sectional structure of a memory device according to the third embodiment;
FIG. 27 is a flowchart illustrating an example of a method for creating map correction values that are used by an exposure apparatus according to a fourth embodiment;
FIG. 28 is a flowchart illustrating an example of a process related to alignment correction of a random component in a semiconductor manufacturing system according to the fourth embodiment;
FIG. 29 is a schematic diagram illustrating an example of a method for improving a bond overlay in a second comparative example;

FIG. 30 is a schematic diagram illustrating examples of a method for improving a bond overlay according to the fourth embodiment;

FIG. 31 is a diagram illustrating examples of the relationship between the amount of warpage of an upper wafer and the polynomial regression coefficient pertaining to a bonded wafer that is manufactured by a semiconductor manufacturing system according to a fifth embodiment;

FIG. 32 is a flowchart illustrating an example of a method for creating map correction values that are used by an exposure apparatus according to the fifth embodiment; and

FIG. 33 is a flowchart illustrating an example of a process related to alignment correction of a random component in the semiconductor manufacturing system according to the fifth embodiment.

DETAILED DESCRIPTION

In general, according to one embodiment, an exposure apparatus is configured to implement an exposure process for exposing a substrate to light. The exposure apparatus includes a stage, a storage device, and a controller. The stage is configured to hold the substrate. The storage device is configured to store a plurality of correction maps each having an alignment correction value that differs from each other. The controller is configured to control in the exposure process an exposure position relative to the substrate by selecting a correction map from the correction maps based on measurement results of a plurality of alignment marks arranged on the substrate or an amount of warpage of the substrate and moving the stage based on the selected correction map.

Hereinafter, embodiments will be described with reference to the drawings. Each embodiment exemplifies an apparatus and a method for embodying the technical concepts of the invention. The drawings are schematic or conceptual. Dimensions, ratios, and the like of each drawing are not necessarily the same as the actual dimensions, ratios, and the like. Where appropriate, illustrations of configurations are omitted. The hatching added to the drawings is not necessarily related to the materials or characteristics of constituent elements. In the present specification, constituent elements having substantially the same functions and configurations have the same reference signs assigned thereto. Numerals and the like appended to the reference signs are referred to using the same reference signs and are used to distinguish between similar elements.

The semiconductor device of the present specification is formed by bonding two semiconductor circuit substrates each having a semiconductor circuit formed thereon, and by dividing the bonded semiconductor circuit substrates into chips. Hereinafter, a semiconductor circuit substrate is referred to as a "wafer". A manufacturing process for bonding two wafers is referred to as the "bonding process". An apparatus that performs the bonding process is referred to as a "bonding apparatus". The wafer disposed on the upper side during the bonding process is referred to as the "upper wafer UW". The wafer disposed on the lower side during the bonding process is referred to as the "lower wafer LW". A set of two bonded wafers, that is, the upper wafer UW and the lower wafer LW is referred to as a "bonded wafer BW". In the present specification, the X direction and the Y direction are directions that intersect each other and that run parallel to the surface of the wafer. The Z direction is a direction that intersects the X direction and the Y direction, respectively, and that is perpendicular to the surface of the wafer. The "wafer surface" is a surface on the side where a semiconductor circuit is formed by a pre-process that will be described subsequently. The "wafer rear surface" is a surface opposite to the surface of the wafer. "Up and down" in the present specification is defined based on a direction along the Z direction.

<Overview of the method for manufacturing a semiconductor device>

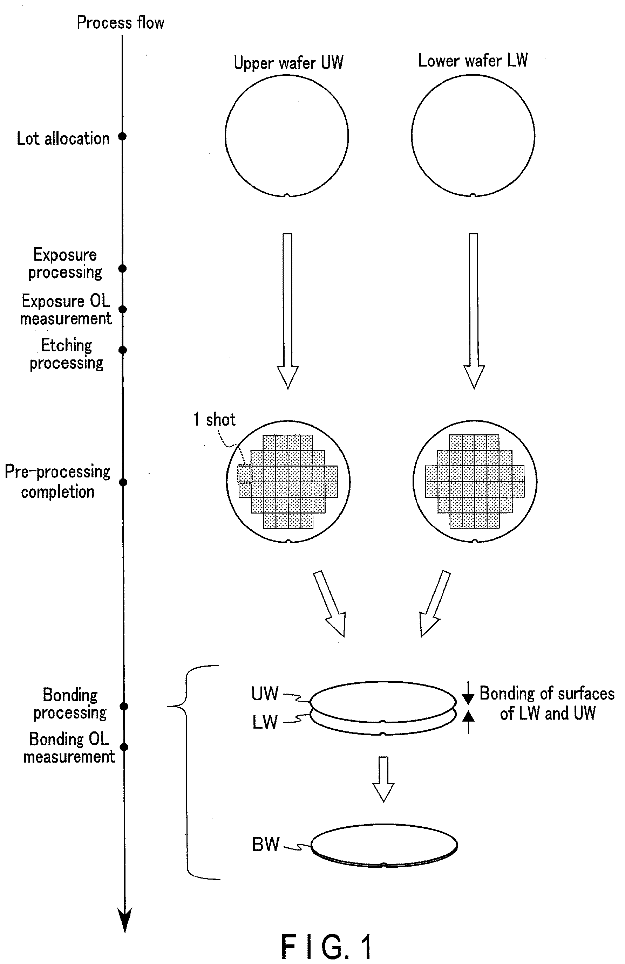

FIG. 1 is a schematic view providing an overview of a method for manufacturing a semiconductor device. The approximate process flow of the method for manufacturing a semiconductor device of the present specification will be described hereinbelow with reference to FIG. 1.

First, a wafer is allocated to a lot ("lot allocation"). A lot may include a plurality of wafers. Lots may be categorized into lots including the upper wafer UW and lots including the lower wafer LW, for example. Thereafter, a pre-process is performed on each of the lots including the upper wafer UW and the lots including the lower wafer LW, and a semiconductor circuit is formed on the upper wafer UW and the lower wafer LW, respectively. A pre-process includes a combination of an "exposure process", "exposure OL (overlay) measurement", and a "etching process".

The exposure process is, for example, a process for transferring a mask pattern to a wafer by irradiating the wafer, which is coated with a resist, with light that is transmitted through the mask. A region to which the mask pattern is transferred through one exposure corresponds to "one shot". The "shot" corresponds to a segregated region of exposure in the exposure process. In the exposure process, one-shot exposure is repeatedly executed with the exposure position shifted. That is, the exposure process is executed using a step-and-repeat method. In the exposure process, the arrangement and shape of each shot are corrected based on measurement results for the alignment marks, which will be described subsequently, and of various correction values, and the like, and the position of overlay with the substrate pattern formed on the wafer is adjusted (aligned). The arrangement (layout) of the plurality of shots in the upper wafer UW and the arrangement (layout) of the plurality of shots in the lower wafer LW are set to be identical. Hereinafter, an apparatus that executes an exposure process is referred to as an "exposure apparatus". The correction values used in the alignment of the overlay position, that is, the control parameters of the exposure apparatus for suppressing the overlay deviation, are referred to as the "alignment correction values". When a polynomial is used to correct the alignment, the coefficient of each term is referred to as an "alignment correction coefficient". That is, the alignment correction values can be calculated based on the alignment correction coefficient for each term, and the exposure position.

The exposure OL measurement is a manufacturing process for measuring overlay deviation amounts between a pattern formed by the exposure process, and a pattern serving as the substrate in the exposure process. The measurement results of the overlay deviation amounts obtained through exposure OL measurement can be used in a determination to rework the exposure process, or to calculate alignment correction values that are to be applied to the subsequent lot, and the like. The etching process is a manufacturing process of etching the wafer by using a mask formed by the exposure process. When the machining process is complete, the used mask is removed and the next process is performed.

When the pre-process is complete (pre-processing completion), a bonding process is performed. In the bonding process, the bonding apparatus arranges the surface of the upper wafer UW and the surface of the lower wafer LW to face each other. Further, in the bonding process, the position of overlay between the pattern formed on the surface of the upper wafer UW and the pattern formed on the surface of the lower wafer LW is adjusted (aligned). Thereafter, the bonding apparatus bonds the surfaces of the upper wafer UW and the lower wafer LW to form a bonded wafer BW.

Bond OL (overlay) measurement is performed on the bonded wafer BW formed by the bonding process. The bond OL measurement is a manufacturing process for measuring overlay deviation amounts between a pattern formed on the surface of the upper wafer UW and a pattern formed on the surface of the lower wafer LW. The measurement results of the overlay deviation amounts obtained through bond OL measurement can be used to calculate alignment correction values that are applied to the exposure process of the subsequent lot, and the like.

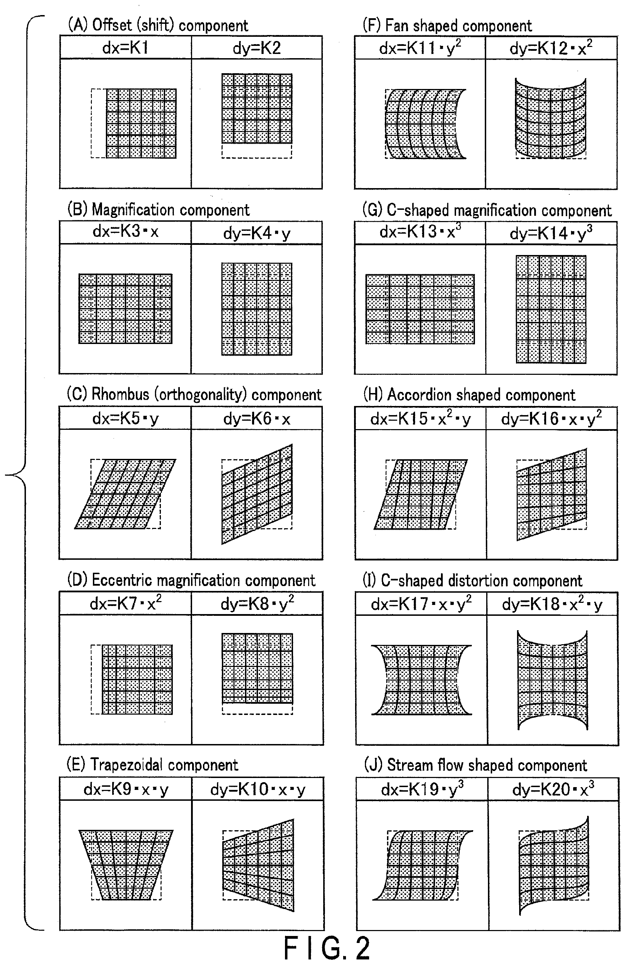

The overlay deviation amounts generated in the exposure process or the bonding process can be expressed by a combination of various components. FIG. 2 is a schematic diagram illustrating examples of overlay deviation components that can occur in a semiconductor device manufacturing process. FIG. 2 illustrates formulae corresponding to each overlay deviation component and changes in the shape of one shot that are based on the formulae. As illustrated in FIG. 2, overlay deviation components include, for example, (A) an offset component, (B) a magnification component, (C) a rhombus (orthogonality) component, (D) an eccentric magnification component, (E) a trapezoidal component, (F) a fan shaped component, (G) a C-shaped magnification component, (H) an accordion shaped component, (I) a C-shaped distortion component, and (J) a stream flow shaped component. Each of the overlay deviation components (A) to (J) of FIG. 2 further includes components in the X direction and the Y direction.

Formulae corresponding to each of the components (A) to (J) of FIG. 2 are listed hereinbelow. Note that, in the following formulae, "x" and "y" respectively correspond to a coordinate (X coordinate) in the X direction and a coordinate (Y coordinate) in the Y direction. "dx" and "dy" are overlay deviation amounts in the X direction and the Y direction, respectively. "K1" to "K20" respectively correspond to coefficients (polynomial regression coefficients) of overlay deviation components.

(A) An offset (shift) component in the X direction is "dx = K1". The offset (shift) component in the Y direction is "dy = K2".
(B) The magnification component in the X direction is "dx = K3·x". The magnification component in the Y direction is "dy = K4·y".
(C) A rhombus (orthogonality) component in the X direction is "dx = K5·y". A rhombus (orthogonality) component in the Y direction is "dy = K6·x".
(D) The eccentricity magnification component in the X direction is "dx = K7·x$^2$". The eccentricity magnification component in the Y direction is "dy = K8·y$^2$".
(E) The trapezoidal component in the X direction is "dx = K9·x·y". The trapezoidal component in the Y direction is "dy = K10·x·y".
(F) The fan shaped component in the X direction is "dx = K11·y$^2$". The fan shaped component in the Y direction is "dy = K12·x$^2$".
(G) The C-shaped magnification component in the X direction is "dx = K13·x$^3$". The C-shaped magnification component in the Y direction is "dy = K14·y$^3$".
(H) The accordion shaped portion in the X direction is "dx = K15·x$^2$·y". (H) The accordion shaped portion in the Y direction is "dy = K16·x·y$^2$".
(I) The C-shaped distortion component in the X direction is "dx = K17·x·y$^2$". The C-shaped distortion component in the Y direction is "dy = K18·x$^2$·y".
(J) The stream flow shaped component in the X direction is "dx = K19·y$^3$". The stream flow shaped component in the Y direction is "dy = K20·x$^3$".

That is, in the present example, the overlay deviation amount Ex in the X direction is calculated by "Ex=K1+K3·x+dy+K5·y+K7·x$^2$+K9·x·y+K11·y$^2$+K13·x$^3$+K15·x$^2$·y+K17· x·y$^2$+K19·y$^3$". The overlay deviation amount Ey in the Y direction is calculated by "Ey = K2+K4·y+K6·x+K8·y$^2$+K10·x·y+K12·x$^2$+K14·y·$^3$+K16·x·y$^2$+K18·x$^2$·y+K 20·x$^3$". When the overlay deviation component is expressed by polynomial regression, not only K1 to K20 but also a coefficient assigned to a higher-order overlay component may be used as the polynomial regression coefficient. In the present specification, K1 to K20 are each referred to as a "K value". That is, the overlay measurement results can be broken down for each K value using polynomial regression.

Note that, although overlay deviation components of shot units are illustrated in FIG. 2, the overlay deviation components generated at the wafer surface can also be expressed using the same overlay deviation components as used for shot units. Hereinafter, the overlay deviation component of a magnification component generated in the wafer surface is also referred to as "wafer magnification". The exposure apparatus and the bonding apparatus each use the measurement results for the alignment marks formed on the wafer in the alignment of the overlay position.

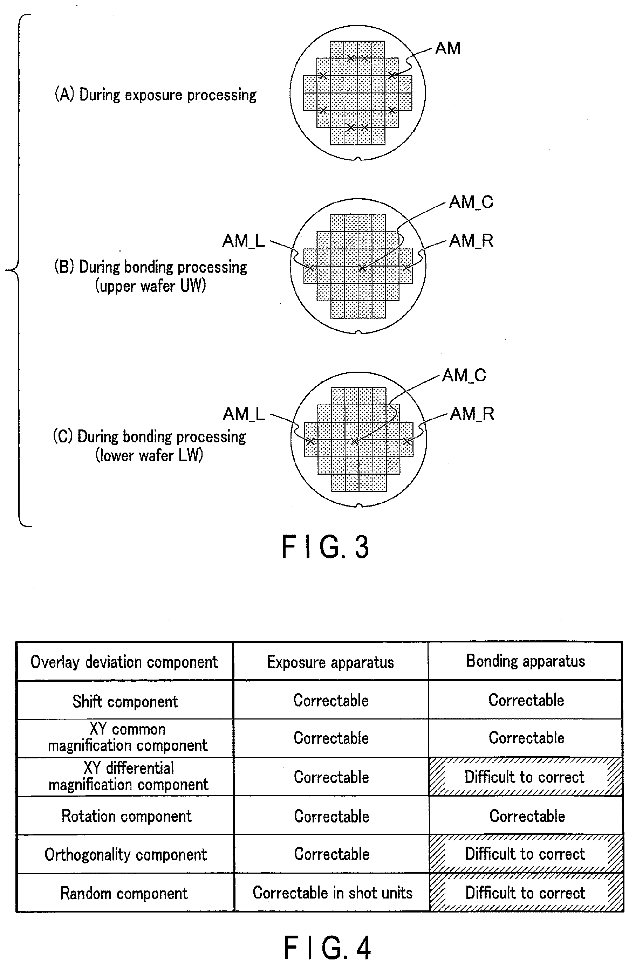

FIG. 3 is a schematic diagram illustrating examples of arrangements of alignment marks used in the semiconductor device manufacturing process. (A) of FIG. 3 illustrates positions of alignment marks AM, which are measured during the exposure process. (B) of FIG. 3 illustrates the position of the alignment marks AM of the upper wafer UW, which are measured during the bonding process. (C) of FIG. 3 illustrates the position of the alignment marks AM of the lower wafer LW, which are measured during the bonding process.

As illustrated in (A) of FIG. 3, the exposure apparatus can, during the exposure process, measure the alignment marks AM at multiple points (at least three or more locations) arranged on the wafer. Further, the exposure apparatus is capable of calculating correction values for the overlay deviation components such as the shift component, the magnification component, and the orthogonality component in the X direction and the Y direction, respectively, by performing, using an orthogonal coordinate system, function approximation of the measurement results for the alignment marks AM at multiple points. As a result, the exposure apparatus is capable of correcting the overlay deviation components of shot units and the overlay deviation components in the wafer surface, respectively.

Furthermore, the exposure apparatus is capable of setting, for each shot, the correction amount of the shift component, the correction amount of the magnification component, and the correction amount of the orthogonality component, for example. In the present specification, an alignment correction method in which alignment correction values, which are set for each shot, are used is referred to as "exposure map correction". A set of alignment correction values for each shot used in the exposure map correction is referred to as the "map correction values". The map correction values can be created based on exposure OL measurement results, bond OL measurement results, or the like. "The map correction values" may also be referred to as the "exposure position correction map" or the "correction map". As the alignment correction values for each shot applied in the exposure map correction, it suffices that at least any of a shift component, a magnification component, and an orthogonality component is used. Thus, the exposure apparatus is capable of correcting complex overlay deviation components.

As illustrated in (B) and (C) of FIG. 3, the bonding apparatus measures at least three alignment marks AM_C, AM_L, and AM_R arranged on the upper wafer UW and the lower wafer LW, respectively, during the bonding process. The alignment mark AM_C is disposed in the vicinity of the center of the wafer. The bonding apparatus aligns a shift component of the wafer based on the measurement results for the alignment mark AM_C. The alignment marks AM_L and AM_R are arranged on one side and on the other side of the outer periphery of the wafer, respectively. The bonding apparatus aligns the rotation component of the wafer (the same orthogonality component in the X direction and the Y direction) based on the measurement results for the alignment marks AM_L and AM_R. As described above, the bonding apparatus is capable of calculating correction values for the shift component and the rotation component by using the alignment marks AM_C, AM_L, and AM_R of at least 3 points and of correcting simple overlay deviation components in the wafer plane.

In addition, the bonding apparatus is capable of correcting the wafer magnification by deforming the stage holding the wafer. When correcting the wafer magnification, the bonding apparatus is capable of using, for example, the wafer magnification alignment correction value used in the exposure process, or a wafer magnification value that is calculated based on the exposure OL measurement results, or the like. Note that the bonding apparatus is capable of measuring the respective alignment marks AM of the upper wafer UW and the lower wafer LW in parallel. For example, because the alignment marks AM_C of the upper wafer UW and the lower wafer LW are simultaneously measured under constraints on the arrangement of the alignment marks AM, the respective alignment marks AM_C of the upper wafer UW and the lower wafer LW are arranged so as to be shifted from the center of the wafer in opposite directions.

FIG. 4 is a table illustrating an example of the correction performance of overlay deviation components in a wafer surface of an exposure apparatus and a bonding apparatus that are used in the semiconductor device manufacturing process; As illustrated in FIG. 4, the shift component can be corrected in both the exposure apparatus and the bonding apparatus. The wafer magnification (XY common magnification component) common in the X direction and the Y direction can be corrected in both the exposure apparatus and the bonding apparatus. The wafer magnification (XY differential magnification component) having a difference between the X direction and the Y direction can be corrected in the exposure apparatus. On the other hand, it is difficult to correct the XY differential magnification component in the bonding apparatus. The rotation component can be corrected in both the exposure apparatus and the bonding apparatus. The rotation component (that is, the orthogonality component), which has a differential between the X direction and the Y direction, can be corrected in the exposure apparatus. On the other hand, it is difficult to correct the orthogonality component in the bonding apparatus. The overlay deviation component (random component), which is randomly generated in the wafer surface, can be corrected in shot units in the exposure apparatus. On the other hand, it is difficult to correct the random component in the bonding apparatus.

<1> First embodiment

In the exposure process, the exposure apparatus 1 according to the first embodiment selects map correction values, which enable random component generation in the bond OL to be suppressed, based on the wafer magnification. Hereinafter, details of the exposure apparatus 1 according to the first embodiment will be described.

<1-1> Configuration

<1-1-1> Configuration of semiconductor manufacturing system PS

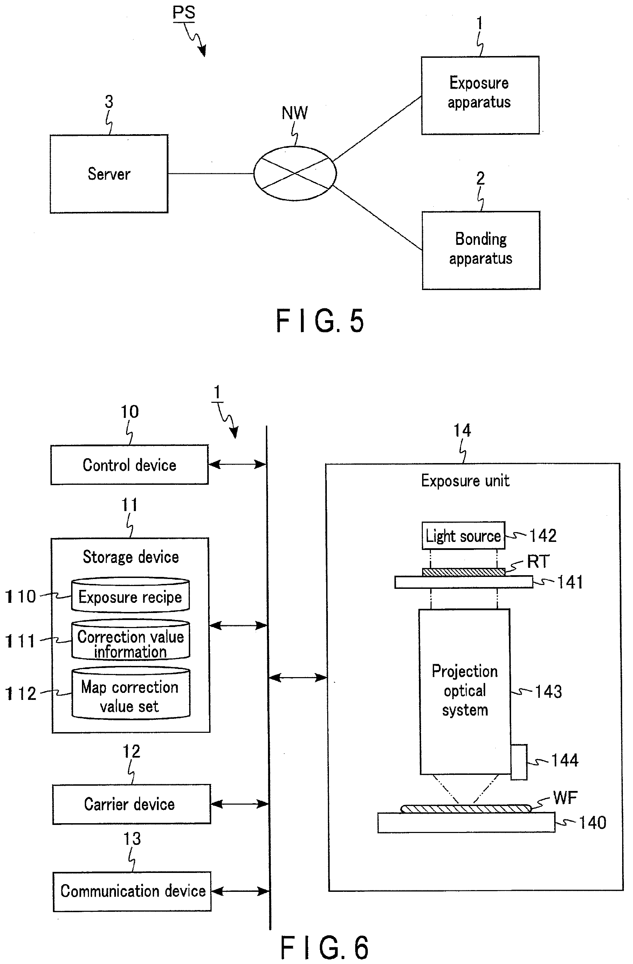

FIG. 5 is a block diagram illustrating an example of a configuration of a semiconductor manufacturing system PS according to the first embodiment. As illustrated in FIG. 5, the semiconductor manufacturing system PS includes, for example, an exposure apparatus 1, a bonding apparatus 2, and a server 3.

The exposure apparatus 1, the bonding apparatus 2, and the server 3 are configured to be capable of communicating via a network NW. Wired communication or wireless communication may be used for the network NW. The bonding apparatus 2 uses the upper wafer UW and the lower wafer LW, for which the exposure apparatus 1 was used in the pre-process, to execute a bonding process and create the bonded wafer BW. The server 3 is, for example, a computer or the like that controls the overall semiconductor device manufacturing process. The server 3 manages correction values that are used in each manufacturing process, and the like. Note that the semiconductor manufacturing system PS can also include an overlay measurement device or the like.

<1-1-2> Configuration of exposure apparatus 1

FIG. 6 is a block diagram illustrating an example of a configuration of the exposure apparatus 1 according to the first embodiment. As illustrated in FIG. 6, the exposure apparatus 1 includes, for example, a control device 10, a storage device 11, a carrier device 12, a communication device 13, and an exposure unit 14.

The control device 10 is a computer or the like that controls the overall operation of the exposure apparatus 1. The control device 10 controls the storage device 11, the carrier device 12, the communication device 13, and the exposure unit 14, respectively. Although not illustrated, the control device 10 is equipped with a central processing unit (CPU), a read only memory (ROM), a random access memory (RAM), and the like. The CPU is a processor that executes various programs relating to the control of devices. The ROM is a non-volatile storage medium that stores a device control program. The RAM is a volatile storage medium that is used as a work area of the CPU.

The storage device 11 is a storage medium that is used for storing data, programs, and the like. The storage device 11 stores, for example, an exposure recipe 110, correction value information 111, and a map correction value set 112. The exposure recipe 110 includes the setting of the exposure process. The exposure recipe 110 includes information such as the shot shape and layout, an exposure amount, a focus setting, and an alignment setting. The exposure recipe 110 can be prepared for each manufacturing process or each lot. The correction value information 111 is a log that records alignment correction values (that is, alignment results) that are used when an exposure process is executed. The map correction value set 112 includes a plurality of map correction values. A map correction value includes an alignment correction value for each shot. A method for creating the map correction values will be described subsequently.

The carrier device 12 is a device that is equipped with a carrier arm capable of carrying a wafer, a transition for temporarily placing a plurality of wafers, and the like. For example, the carrier device 12 carries the wafer WF received from an external coating-development device to the exposure unit 14, for example. In addition, after the exposure process, the carrier device 12 carries the wafer WF received from the exposure unit 14 to outside the exposure apparatus 1. Note that the "coating-development device" is a device that executes a pre-process and a post-process of the exposure process. The pre-process of the exposure process includes a process for using a resist material (photosensitive material) to coat the wafer. The post-process of the exposure process includes a process for developing a pattern with which the wafer is exposed. Note that a plurality of semiconductor manufacturing devices may also be used as devices used in the pre-process and post-process of the exposure process.

The communication device 13 is a communication interface capable of connecting to a network. The exposure apparatus 1 may operate based on an operation by a terminal on the network, or may store the exposure recipe 110 and the correction value information 111 in a server on the network.

The exposure unit 14 is a set of configurations used in the exposure process. The exposure unit 14 includes, for example, a wafer stage 140, a reticle stage 141, a light source 142, a projection optical system 143, and a camera 144. The wafer stage 140 has a function for holding a wafer WF. The reticle stage 141 has a function for holding a reticle RT (mask). The respective stage positions of the wafer stage 140 and the reticle stage 141 can be controlled based on control by the control device 10. The light source 142 irradiates the reticle RT with generated light. The projection optical system 143 collects the light transmitted through the reticle RT onto the surface of the wafer WF. The camera 144 is an imaging mechanism that is used to measure the alignment marks AM.

<1-1-3> Configuration of bonding apparatus 2

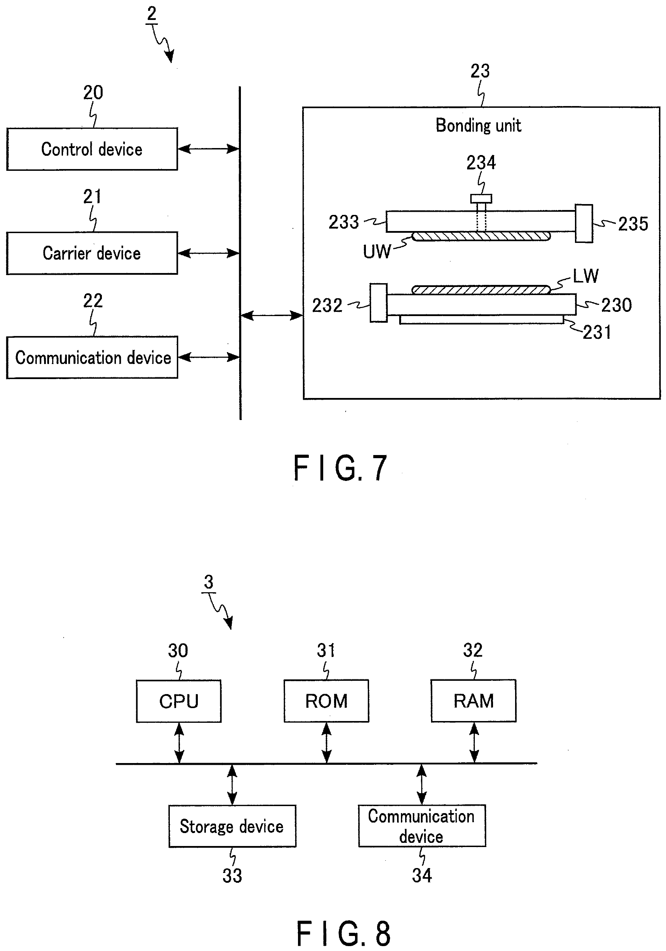

FIG. 7 is a block diagram illustrating an example of a configuration of the bonding apparatus 2 according to the first embodiment. As illustrated in FIG. 7, the bonding apparatus 2 includes, for example, a control device 20, a carrier device 21, a communication device 22, and a bonding unit 23.

The control device 20 is a computer or the like that controls the overall operation of the bonding apparatus 2. The control device 20 controls the carrier device 21, the communication device, and the bonding unit 23, respectively. Although not illustrated, the control device 20 is equipped with a CPU, a ROM, a RAM, and the like, similarly to the exposure apparatus 1.

The carrier device 21 is a device that is equipped with a carrier arm capable of carrying a wafer, and a transition for temporarily placing a plurality of wafers, and the like. For example, the carrier device 21 carries the upper wafer UW and the lower wafer LW received from a pre-process device of the bonding process to the bonding unit 23. In addition, the carrier device 21 carries the bonded wafer BW received from the bonding unit 23 to outside the bonding apparatus 2 after the bonding process. The carrier device 21 may include a mechanism for vertically inverting the wafer.

The communication device 22 is a communication interface capable of connecting to network NW. The bonding apparatus 2 may operate based on control of a terminal on the network NW, may store an operation log on the server 3 on the network NW, or may calculate alignment correction values based on information stored on the server 3.

The bonding unit 23 is a set of configurations used in the bonding process. The bonding unit 23 includes, for example, a lower stage 230, a stress device 231, a camera 232, an upper stage 233, a pushpin 234, and a camera 235. The lower stage 230 has a function for holding the lower wafer LW. The lower stage 230 includes, for example, a wafer chuck that holds the wafer through vacuum suction. The stress device 231 has a function for applying stress to the lower stage 230 and for deforming the lower wafer LW via the lower stage 230. The expansion amount (scaling) of the lower wafer LW held by the lower stage 230 changes according to the amount of deformation of the lower stage 230 by the stress device 231. The camera 232 is an imaging mechanism that is disposed on the lower stage 230 side and that is used to measure the alignment marks AM of the upper wafer UW. The upper stage 233 has a function for holding the upper wafer UW. The upper stage 233 includes, for example, a wafer chuck that holds the wafer through vacuum suction. The pushpin 234 is a pin that can be driven in the up-down direction based on the control by the control device 20 to press the upper surface of the center portion of the upper wafer UW held by the upper stage 233. The camera 235 is an imaging mechanism that is disposed on the upper stage 233 side and that is used to measure the alignment marks AM of the lower wafer LW. The bonding apparatus 2 may have a vacuum pump that is used for vacuum suction of the lower stage 230 and the upper stage 233.

Note that the lower stage 230 and the upper stage 233 are configured such that the lower wafer LW held by the lower stage 230 and the upper wafer UW held by the upper stage 233 can be arranged to face each other. That is, the upper stage 233 can be disposed above the lower stage 230. In other words, the lower stage 230 and the upper stage 233 can face each other. In the bonding process, the upper surface of the upper wafer UW is the back surface of the upper wafer UW and is held on the upper stage 233 of the bonding apparatus 2. In the bonding process, the lower surface of the upper wafer UW is a surface of the upper wafer UW and corresponds to the bonding surface. The upper surface of the lower wafer LW is the surface of the lower wafer LW and corresponds to the bonding surface. The lower surface of the lower wafer LW is the back surface of the lower wafer LW and is held by the lower stage 230 of the bonding apparatus 2. The bonding apparatus 2 is capable of adjusting the shift component and the rotation component of the overlay deviation by adjusting the relative positions of the lower stage 230 and the upper stage 233. The bonding apparatus 2 is also capable of adjusting the XY common wafer magnification of the lower wafer LW held by the deformed lower stage 230 by using the stress device 231 to deform the lower stage 230.

Note that the above-mentioned "bonding-process pre-process device" is a device having a function for modifying and hydrophilizing the bonding surfaces of the upper wafer UW and the lower wafer LW so as to enable bonding, before the bonding process by the bonding apparatus 2. In brief, the pre-process device first performs a plasma process on the respective surfaces of the upper wafer UW and the lower wafer LW and modifies the respective surfaces of the upper wafer UW and the lower wafer LW. In the plasma process, oxygen ions or nitrogen ions are generated based on oxygen gas or nitrogen gas, which is the treatment gas, under a predetermined reduced atmosphere, and the generated oxygen ions or nitrogen ions are applied to the bonding surface of each wafer. Thereafter, the pre-process device supplies pure water to the respective surfaces of the upper wafer UW and the lower wafer LW. Thereupon, hydroxyl groups adhere to the respective surfaces of the upper wafer UW and the lower wafer LW, and the surfaces are hydrophilized. In the bonding process, the upper wafer UW and the lower wafer LW, the bonding surfaces of which have been modified and hydrophilized as described above, are used. The bonding apparatus 2 may be combined with a pre-process device or the like to constitute a bonding system.

<1-1-4> Configuration of server 3

FIG. 8 is a block diagram illustrating an example of a configuration of a server 3 according to the first embodiment. As illustrated in FIG. 8, the server 3 includes, for example, a CPU 30, a ROM 31, a RAM 32, a storage device 33, and a communication device 34. The CPU 30 is a processor that executes various programs relating to control of the server 3. The ROM 31 is a non-volatile storage device that stores a control program of the server 3. The RAM 32 is a volatile storage device that is used as a work area of the CPU 30. The storage device 33 is a nonvolatile storage medium that is capable of storing information received from the exposure apparatus 1, the bonding apparatus 2, or the like. The communication device 34 is a communication interface capable of connecting to network NW.

<1-2> Method for manufacturing semiconductor device

Hereinafter, as a method for manufacturing a semiconductor device according to the first embodiment, an example of a specific process using the exposure apparatus 1 will be described. That is, a semiconductor device is manufactured using the exposure method (exposure process) of the first embodiment described hereinbelow.

<1-2-1> Overview of exposure process

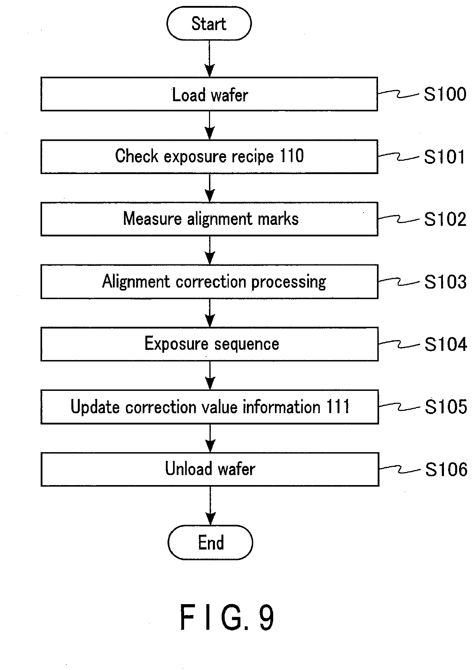

FIG. 9 is a flowchart illustrating an example of an exposure process of the exposure apparatus 1 according to the first embodiment. Hereinafter, an overview of the exposure process by the exposure apparatus 1 will be described with reference to FIG. 9.

When the completion of the wafer pre-process is reported by the coating-development device, the exposure apparatus 1 starts the exposure process (Start).

First, the exposure apparatus 1 loads a wafer (S100). The wafer loaded from the coating-development device is held by the wafer stage 140.

Next, the exposure apparatus 1 checks the exposure recipe 110 (S101). As a result, the control device 10 determines process conditions to be applied to the loaded wafer.

Next, the exposure apparatus 1 measures the alignment marks AM (S102). More specifically, the camera 144 photographs a plurality of alignment marks AM arranged in predetermined positions on the wafer.

Next, the exposure apparatus 1 executes an alignment correction process (S103). More specifically, the control device 10 calculates alignment correction values for shot arrangements and shot shapes with which the wafer is to be exposed, based on the measurement results of the plurality of alignment marks AM. Furthermore, the exposure apparatus 1 according to the first embodiment selects a map correction value based on the wafer magnification correction values that are included in the calculated alignment correction values, and uses these values for the alignment. For this reason, in the exposure apparatus 1 according to the first embodiment, in a case where the exposure process is continuously performed with respect to a plurality of wafers included in one lot, different map correction values can be applied for each wafer.

Next, the exposure apparatus 1 executes an exposure sequence (S104). More specifically, the control device 10 controls the light source 142, the wafer stage 140, and the reticle stage 141 based on the alignment correction values calculated in S103, and irradiates the wafer with the light transmitted through the mask by using a step-and-repeat method.

Next, the exposure apparatus 1 updates the correction value information 111 (S105). That is, in S105, the alignment correction values calculated in S103 are recorded in the correction value information 111 in association with the processed wafer.

Next, the exposure apparatus 1 unloads the wafer (S106). The unloaded wafer is delivered to the coating-development device. The coating-development device performs processes such as a heat treatment, development, and cleaning with respect to the wafer for which the exposure process has been completed. Thus, a pattern is formed on the wafer.

When the wafer is unloaded, the exposure apparatus 1 ends the exposure process (End).

<1-2-2> Outline of bonding process

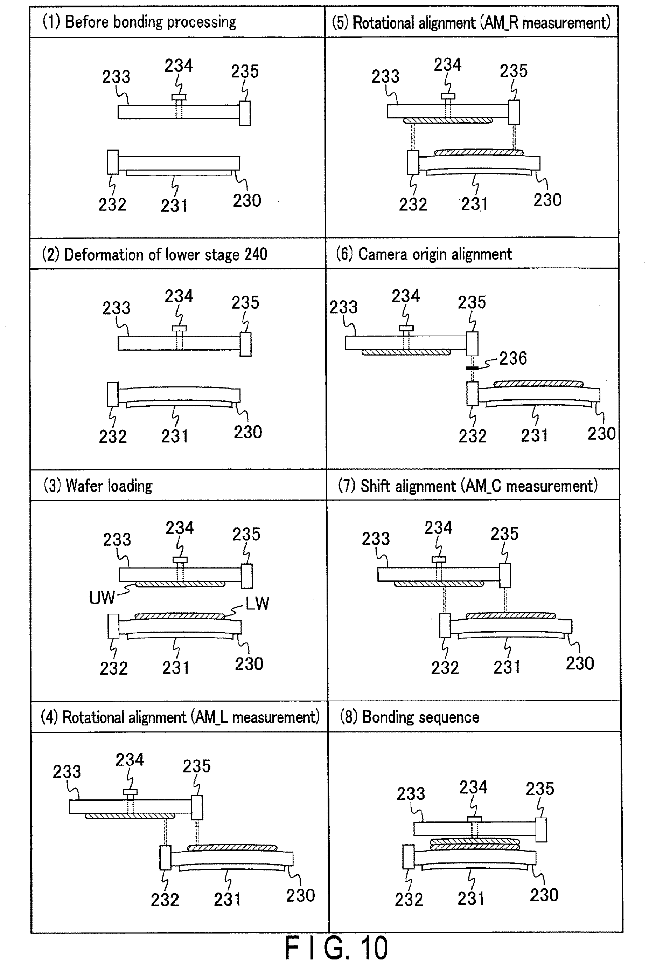

FIG. 10 is a schematic view illustrating an overview of a bonding process by the bonding apparatus 2 according to the first embodiment. In the bonding process, each of (1) to (8) of FIG. 10 illustrates a state of the bonding unit 23 in the bonding process. Hereinafter, an outline of the bonding process will be described with reference to FIG. 10. Note that, in the following description, alignment of the shift component is referred to as "shift alignment", and alignment of the rotation component is referred to as "rotational alignment".

(1) of FIG. 10 illustrates a state of the bonding unit 23 before the bonding process.

Upon starting the bonding process, the control device 20 controls the stress device 241 based on common wafer magnification alignment correction values in the X direction and the Y direction, thereby deforming the lower stage 240 as illustrated in (2) of FIG. 10. Note that the bonding apparatus 2 may acquire such alignment correction values from the server 3 or may calculate the alignment correction values based on the alignment correction values acquired from the exposure apparatus 1 or the server 3.

Next, the control device 20 causes the carrier device 21 to carry the lower wafer LW to the lower stage 230 and to carry the upper wafer UW to the upper stage 233. Further, as illustrated in (3) of FIG. 10, the control device 20 causes the lower stage 230 to hold the lower wafer LW and causes the upper stage 233 to hold the upper wafer UW. Note that the respective surfaces of the upper wafer UW and the lower wafer LW, which are carried to the bonding apparatus 2, are modified and hydrophilized by a pre-process device for a bonding process.

Next, the control device 20 executes rotational alignment. More specifically, first, as illustrated in (4) of FIG. 10, the control device 20 controls the positions of the lower stage 230 and the upper stage 233, aligns the optical axis of the camera 232 of the lower stage 230 with the position of the alignment mark AM_L of the upper wafer UW, and aligns the optical axis of the camera 235 of the upper stage 233 with the position of the alignment mark AM_L of the lower wafer LW. Further, the control device 20 measures the alignment mark AM_L of the upper wafer UW by using the camera 232, and measures the alignment mark AM_L of the lower wafer LW by using the camera 235.

Next, as illustrated in (5) of FIG. 10, the control device 20 controls the positions of the lower stage 230 and the upper stage 233 to align the optical axis of the camera 232 of the lower stage 230 with the position of the alignment mark AM_R of the upper wafer UW and align the optical axis of the camera 235 of the upper stage 233 with the position of the alignment mark AM_R of the lower wafer LW. Further, the control device 20 measures the alignment mark AM_R of the upper wafer UW by using the camera 232, and measures the alignment mark AM_R of the lower wafer LW by using the camera 235. Thereafter, the control device 20 calculates the correction amount of the overlay deviation of the rotation component based on the measurement results of the alignment marks AM_L and AM_R by the cameras 232 and 235 acquired by the processes of (4) and (5) of FIG. 10.

Next, the control device 20 executes camera origin alignment. More specifically, as illustrated in (6) of FIG. 10, the control device 20 controls the positions of the lower stage 230 and the upper stage 233, and inserts a common target 236 between the optical axis of the camera 232 of the lower stage 230 and the optical axis of the camera 235 of the upper stage 233. Thereafter, the control device 20 aligns the origin of each of the cameras 232 and 235 based on the measurement results of the common target 236 by each of the cameras 232 and 235.

Next, the control device 20 executes shift alignment. More specifically, first, as illustrated in (7) of FIG. 10, the control device 20 controls the positions of the lower stage 230 and the upper stage 233, aligns the optical axis of the camera 232 of the lower stage 230 with the position of the alignment mark AM_C of the upper wafer UW, and aligns the optical axis of the camera 235 of the upper stage 233 with the position of the alignment mark AM_C of the lower wafer LW. Further, the control device 20 measures the alignment mark AM_C of the upper wafer UW by using the camera 232, and measures the alignment mark AM_C of the lower wafer LW by using the camera 235. Thereafter, the control device 20 calculates the alignment correction values for the shift component based on the respective measurement results for the alignment mark AM_C of the lower wafer LW and the upper wafer UW.

Next, the control device 20 executes a bonding sequence as illustrated in (8) of FIG. 10. More specifically, first, the control device 20 performs horizontal alignment based on the alignment correction values calculated by the rotational alignment and the shift alignment and the calibration result of the camera origin, and adjusts the relative position between the lower stage 230 and the upper stage 233. Further, the control device 20 brings the position of the upper stage 233 close to the lower stage 230 to adjust the interval between the upper wafer UW and the lower wafer LW. Thereafter, the control device 20 pushes down the center portion of the upper wafer UW by lowering the pushpin 244 to bring the surface of the upper wafer UW into contact with the surface of the lower wafer LW.

Thereafter, the control device 20 sequentially releases the holding (vacuum suction) of the upper wafer UW by the upper stage 243 from the inside to the outside. Thereupon, the upper wafer UW drops onto the lower wafer LW, and the surface of the upper wafer UW and the surface of the lower wafer LW are bonded. More specifically, a van der Waals force (intermolecular force) is generated between the modified bonding surface of the upper wafer UW and the modified bonding surface of the lower wafer LW, and the contact portions of the upper wafer UW and the lower wafer LW are bonded. Furthermore, because the respective bonding surfaces of the upper wafer UW and the lower wafer LW are hydrophilized, the hydrophilic group at the contact portion between the upper wafer UW and the lower wafer LW is hydrogen-bonded (intermolecular force), and the contact portion between the upper wafer UW and the lower wafer LW is more firmly bonded.

<1-2-3> Specific example of bonding sequence

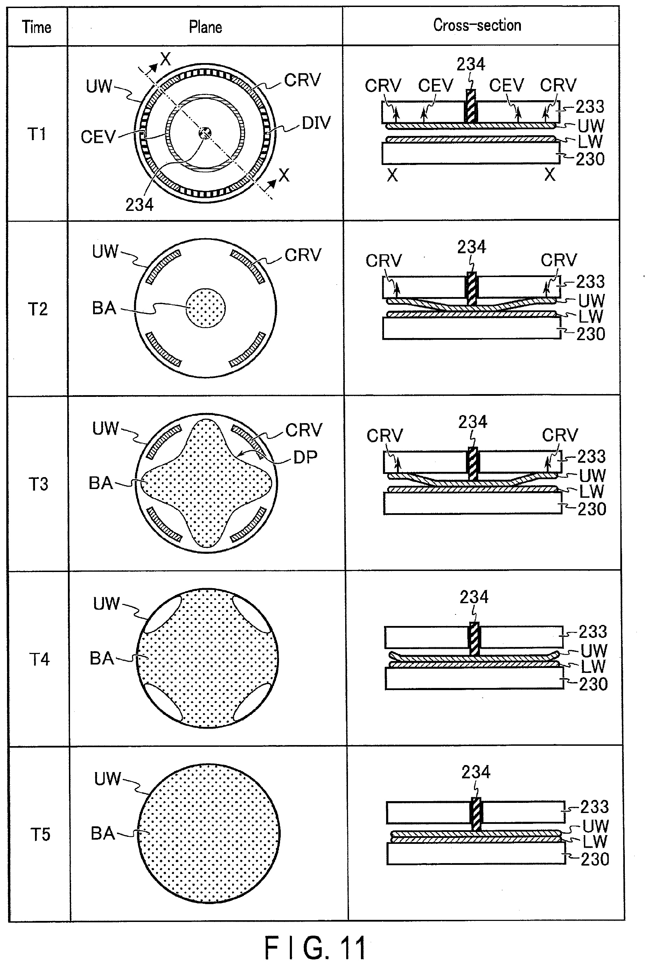

FIG. 11 is a schematic diagram illustrating a specific example of a bonding sequence of the bonding apparatus 2 according to the first embodiment. Times T1 to T5 in FIG. 11 indicate consecutive times in the bonding sequence. "Plane" in FIG. 11 indicates a state of vacuum suction to the upper wafer UW, and a bonding progress state. "Cross-section" in FIG. 11 indicates a cross-section of the upper wafer UW taken along line X-X indicated by "plane" in FIG. 11. Hereinafter, a specific example of the bonding sequence will be described with reference to FIG. 11.

First, the upper wafer UW is held on the upper stage 233 through vacuum suction in each of the regions CRV, DIV, and CEV (time T1). More specifically, the four regions CRV are arranged so as to each include an X-shaped vertex portion. The four regions DIV are arranged so as to each include a cross-shaped vertex portion. The regions CRV and DIV are alternately arranged in the vicinity of the outer periphery of the upper wafer UW. Thus, the combination of the regions CRV and DIV forms a ring-shaped region in the vicinity of the outer periphery of the upper wafer UW. The region CEV is a ring-shaped region surrounding the center portion of the upper wafer UW in plan view, and is surrounded by a set of the regions DIV and CRV. The pushpin 334 is disposed in the center portion of the region CEV.

Further, the control device 20 releases the vacuum suction of each of the regions DIV and CEV, uses the pushpin 234 to push down the center portion of the upper wafer UW, thereby bringing the surface of the upper wafer UW and the surface of the lower wafer LW into contact with each other. Thereupon, the bonding region BA spreads from the center portion of the upper wafer UW toward the outer periphery (time T2).

When the time elapses from the time T2, in the upper wafer UW, bonding proceeds in the portion of the adjacent region CRV. On the other hand, the bonding in the portion of the region CRV of the upper wafer UW does not proceed because the vacuum suction is performed by the upper stage 233 (time T3). Such a difference in the progress of bonding may cause local stress in the upper wafer UW. As a result, the portion where the local stress is generated in the upper wafer UW can be bonded to the lower wafer LW in a distorted state. Hereinafter, a portion where the upper wafer UW is bonded to the lower wafer LW in a distorted state is referred to as the "distorted portion DP".

Thereafter, the control device 20 releases the vacuum suction of the region CRV. Thereupon, the portion of the upper wafer UW held on the upper stage 233 in the region CRV falls to the lower wafer LW side, and the bonding region BA is formed up to the outermost periphery of the upper wafer UW as time elapses (times T4 to T5). That is, the bonding region BA is formed on the whole surface of the bonding surface between the upper wafer UW and the lower wafer LW, and the bonding between the upper wafer UW and the lower wafer LW in the bonding sequence is complete.

<1-2-4> Method for creating map correction values

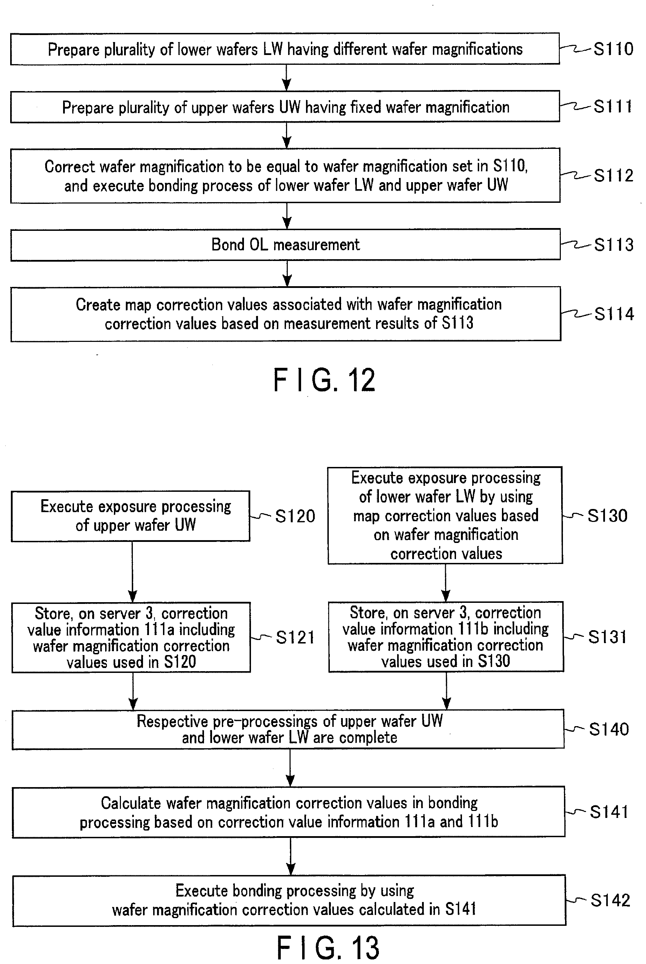

FIG. 12 is a flowchart illustrating an example of a method for creating map correction values that are used by an exposure apparatus 1 according to the first embodiment. Hereinafter, an example of a method for creating map correction values will be described with reference to FIG. 12.

First, a plurality of lower wafers LW exposed by changing the wafer magnification in a predetermined exposure process is prepared. (S110). That is, in S110, two or more lower wafers LW having different wafer magnifications are prepared. The predetermined exposure process in S110 corresponds to the exposure process of the wiring layer in the vicinity of the surface of the lower wafer LW, and is a process that has a large effect on the bond OL. Throughout the present specification, this exposure process will also be referred to as a "bonding-surface exposure process for the lower wafers LW".

Next, a plurality of upper wafers UW, which have been exposed at a fixed wafer magnification in a predetermined exposure process, are prepared. (Sill). The predetermined exposure process in Sill corresponds to the exposure process of the wiring layer in the vicinity of the surface of the upper wafer UW, and is a process that has a large effect on the bond OL. Throughout the present specification, this exposure process will also be referred to as a "bonding-surface exposure process for the upper wafers UW".

Next, the wafer magnification of each of the plurality of lower wafers is corrected so that the wafer magnification set in S110 becomes equal to the wafer magnification set in S111, and bonding process of the lower wafer LW and the upper wafer UW is executed (S112). That is, in S112, the lower wafer LW is held in a state where the lower stage 230 is deformed into a shape that is based on the wafer magnification that was set in S110, and the lower wafer LW and the upper wafer UW are bonded. Thus, the bonding process corrected in accordance with the wafer magnification of the upper wafer UW is executed for each of the lower wafers LW that have different wafer magnifications.

Next, bond OL measurement is executed (S113). Through this bond OL measurement, the bond OL measurement results are obtained for each wafer magnification that was set in S110. The bond OL measurement results are stored on the server 3, for example.

Next, the server 3 creates map correction values in which wafer magnification correction values and the bond OL measurement results are associated with each other based on the bond OL measurement results of S113 (S114). Further, the plurality of map correction values thus created are stored in the storage device 11 of the exposure apparatus 1 as the map correction value set 112. Each map correction value is associated with, for example, mutually different wafer magnification correction values in a predetermined range. This predetermined range is set based on the wafer magnification correction values set in S110, for example.

<1-2-5> Process flow from exposure process to bonding process

FIG. 13 is a flowchart illustrating an example of a process related to alignment correction of a random component in the semiconductor manufacturing system PS according to the first embodiment. Hereinafter, the process flow from the exposure process to the bonding process of the first embodiment will be described with reference to FIG. 13.

First, the respective pre-processings of the upper wafer UW and the lower wafer LW are executed. More specifically, in the pre-process of the upper wafer UW, the exposure process of the upper wafer UW is executed (S120). The correction value information 111a that includes the wafer magnification correction values used in the exposure process of S120 is stored on the server 3 (S121). On the other hand, in the pre-process of the lower wafer LW, the exposure process of the lower wafer LW is executed using map correction values that are based on the wafer magnification correction values being used (S130). More specifically, in the exposure process of S130, the exposure apparatus 1 calculates the alignment correction coefficient of the magnification component at the wafer surface based on the measurement results of the alignment marks at at least three points, and selects one correction map from the plurality of correction maps based on the magnitude of the calculated alignment correction coefficient of the magnification component. For example, the exposure apparatus 1 selects, as the map correction value to be applied to a wafer that has a large wafer magnification, a map correction value that was created based on bond OL measurement results for a bonded wafer BW that was obtained using a lower wafer LW set with a large wafer magnification in S110. In addition, the exposure apparatus 1 selects, as the map correction value to be applied to a wafer that has a small wafer magnification, a map correction value that was created based on the bond OL measurement results for a bonded wafer BW that was obtained using a lower wafer LW set with a small wafer magnification in S110. Further, the correction value information 111b that includes the wafer magnification correction values used in the exposure process of S130 is stored on the server 3 (S131).

When the respective pre-processings of the upper wafer UW and the lower wafer LW are complete (S140), the server 3 calculates the wafer magnification correction values in the bonding process based on the correction value information 111a and 111b stored in S121 and S131 respectively (S141). More specifically, in S141, the server 3 calculates the difference between the process value (alignment correction value + overlay correction value) for wafer magnification of the upper wafer UW and the process value (alignment correction value + overlay correction value) for wafer magnification of the lower wafer LW. Further, the server 3 feeds forward the calculation results of S141 to the bonding apparatus 2. Note that, in this example, "alignment correction value" is a correction value of the overlay deviation component that is calculated based on the measurement results for the alignment marks AM. The "overlay correction value" is, for example, a correction value that is calculated based on exposure OL measurement results in advanced process control executed at the time of a large-scale lot process.

Thereafter, the bonding apparatus 2 executes the bonding process by using the wafer magnification correction value calculated in S141. That is, the bonding apparatus 2 determines the wafer magnification correction value in the bonding process based on the respective exposure process alignment results for the upper wafer UW and the lower wafer LW in the pre-process. In other words, in the bonding process, the bonding apparatus 2 controls the stress device 231, based on the difference between the alignment results of the respective exposure processes of the upper wafer UW and the lower wafer LW in the pre-process, to deform the lower stage 230 ((2) in FIG. 10). Other operations in the bonding process are similar to the operations described using FIG. 10.

Note that, in the above description, a case has been exemplified in which the wafer magnification correction values in the bonding process are determined using the server 3, but the present invention is not limited thereto. The exposure apparatus 1 or the bonding apparatus 2 may calculate the wafer magnification correction values in the bonding process. In this case, information regarding the wafer magnification correction values is exchanged between the exposure apparatus 1 and the bonding apparatus 2. When there is no map correction value associated with the wafer magnification correction values, the exposure apparatus 1 may use map correction values associated with the wafer magnification correction values which are close to the wafer magnification correction values, or may use map correction values which have been calculated based on a combination of a plurality of map correction values. In addition, the exposure apparatus 1 or the server 3 may create a relational expression between the wafer magnification and the correction values for each shot based on a plurality of combinations of the wafer magnification and the map correction values, and map correction values which are based on this relational expression may be used in the exposure process.

<1-3> Advantageous effects of first embodiment

With the exposure apparatus 1 according to the first embodiment described hereinabove, it is possible to improve semiconductor device yield. Hereinafter, the advantageous effects of the exposure apparatus 1 according to the first embodiment will be described in detail.

In the case of a semiconductor device formed by bonding two wafers, the states of wafer magnification (that is, the sizes of the wafers) before one wafer is bonded to the other wafer may be different. For example, the wafer magnification may vary depending on the film stress (that is, the warpage of the wafer) on the front and back surfaces, respectively, of the wafer. For this reason, the variation in the wafer magnification may be different between one wafer and the other wafer, depending on the design of the circuit, the elements, and the like. In addition, as described with reference to FIG. 3, it is difficult for the bonding apparatus 2 to correct the overlay deviation of the random component. Therefore, the distortion portion DP described with reference to FIG. 11 may cause overlay deviation of the random component in the bond OL (overlay). As a method of suppressing the overlay deviation of the random component in the bonded wafer BW, it is conceivable to use exposure map correction that improves the bond OL in a predetermined exposure process in the previous process.

Here, an example of a method for improving a bond overlay according to the first embodiment will be described using a comparative example. In this example, it is assumed that the variation in the wafer magnification in the pre-process of the upper wafer UW is small and that the variation in the wafer magnification in the pre-process of the lower wafer LW is large. In the following description, "overlay is favorable" corresponds to the suppression, in the exposure process, of overlay deviation between the substrate pattern and the pattern formed by the exposure process, and corresponds to suppression, in the bonding process, of overlay deviation between the pattern of the upper wafer UW and the pattern of the lower wafer LW. "Poor overlay" corresponds to the presence of a portion where the overlay deviation between the substrate pattern and the pattern formed by the exposure process is large in the exposure process, and corresponds to the presence of a portion where the overlay deviation between the pattern of the upper wafer UW and the pattern of the lower wafer LW is large in the bonding process.

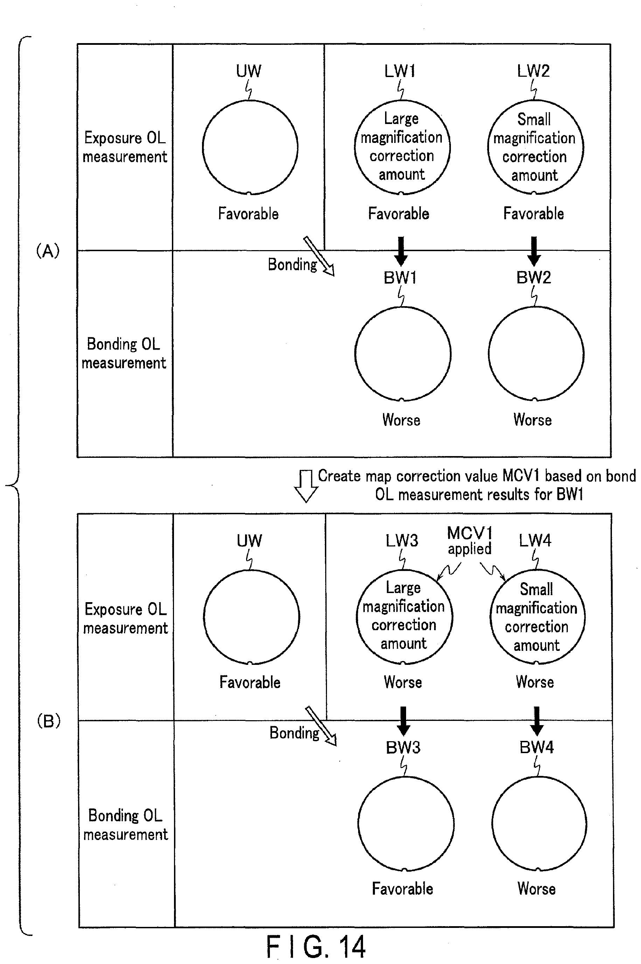

FIG. 14 is a schematic diagram illustrating an example of a method for improving a bond overlay in the first comparative example. (A) and (B) of FIG. 14 correspond to before and after applying the exposure map correction, respectively, and illustrate the respective results for exposure OL measurement and bond OL measurement of the lot. Note that it is assumed that the overlay in the exposure OL of the upper wafer UW is favorable before and after applying the exposure map correction, respectively.

As illustrated in (A) of FIG. 14, in the exposure process of the pre-process, the lower wafer LW1 has a large correction amount for wafer magnification (a large magnification correction amount), and the lower wafer LW2 has a small correction amount for wafer magnification (a small magnification correction amount). In the exposure OL measurement of each of the lower wafers LW1 and LW2, the overlay is favorable. Further, the bonding process is executed by correcting the wafer magnification of each of the lower wafers LW1 and LW2. In this example, the overlay deviation of the random component, which is based on correction of the wafer magnification in the bonding process, remains for the bonded wafer BW1, which is obtained by bonding the lower wafer LW1 and the upper wafer UW, and the bonded wafer BW2, which is obtained by bonding the lower wafer LW2 and the upper wafer UW, respectively. Therefore, in the bond OL measurement of each of the bonded wafers BW1 and BW2, the overlay becomes worse.

In the first comparative example, a map correction value MCV1 is created based on the bond OL measurement results for the bonded wafer BW1, and the map correction value MCV1 is used for process of subsequent lots. Thereupon, as illustrated in (B) of FIG. 14, in the exposure OL measurement of the subsequent lot, the exposure OL of the lower wafer LW3, which has a large correction amount for wafer magnification and the lower wafer LW4, which has a small correction amount for wafer magnification, respectively, may be worsened by applying the map correction value MCV1. This is because the use of the map correction values capable of improving the overlay of the bonding process may cause an overlay deviation between the pattern formed by the exposure process and the substrate pattern. Because the map correction value MCV1 is used in the exposure process of the lower wafer LW3, the bond OL measurement results for the bonded wafer BW3, obtained by bonding the lower wafer LW3 and the upper wafer UW, may be favorable because the overlay deviation of the random component is suppressed. However, the overlay deviation tendency of the random component may change according to the wafer magnification correction amount. For this reason, in the case of the bonded wafer BW4, which is obtained by bonding the lower wafer LW4 to the upper wafer UW, because the map correction value MCV1 corresponding to a "large magnification correction amount" is used while the magnification correction amount in the exposure process is small, the improvement amount of the overlay deviation of the random component may be worse than that of the bonded wafer BW3.

Therefore, the exposure apparatus 1 according to the first embodiment has a function for selecting the map correction value MCV to be used according to the wafer magnification correction value in the exposure process.

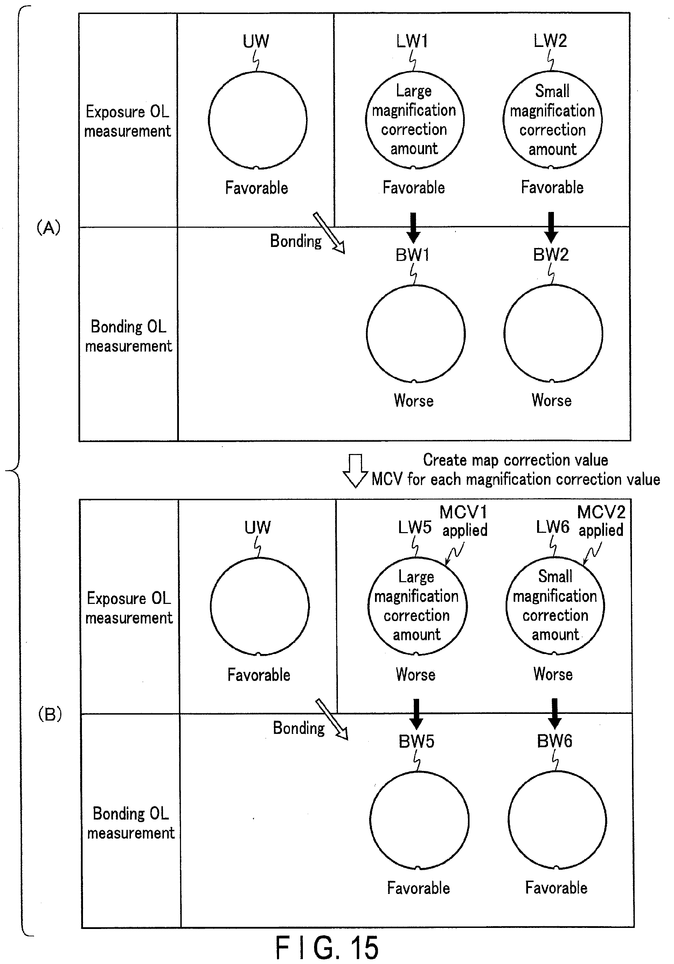

FIG. 15 is a schematic diagram illustrating examples of a method for improving a bond overlay according to the first embodiment. (A) and (B) of FIG. 15 correspond to before and after applying the exposure map correction of the first embodiment, respectively, and illustrate the respective results of the exposure OL measurement and bond OL measurement of a lot. Note that it is assumed that the overlay in the exposure OL of the upper wafer UW is favorable before and after applying the exposure map correction, respectively. As illustrated in (A) of FIG. 15, an example before application of the exposure map correction of the first embodiment is similar to an example before application of the exposure map correction of the first comparative example.

In the first embodiment, the map correction value MCV1 is created based on the wafer magnification correction amount used in the exposure process of the lower wafer LW1 and the bond OL measurement results for the bonded wafer BW1, and a map correction value MCV2 is created based on the wafer magnification correction amount used in the exposure process of the lower wafer LW2 and the bond OL measurement results for the bonded wafer BW2. Further, the map correction values MCV1 and MCV2 are each stored in the storage device 11 of the exposure apparatus 1 as the map correction value set 112. Further, the map correction value set 112 is used for process of subsequent lots.

Thereupon, as illustrated in (B) of FIG. 14, in the exposure process of the subsequent lot in the first embodiment, the map correction value MCV corresponding to the wafer magnification correction amount is used. More specifically, the map correction value MCV1 associated with "large magnification correction amount" is applied to a lower wafer LW5 that has a large wafer magnification correction amount. The map correction value MCV2 associated with "small magnification correction amount" is applied to a lower wafer LW6 that has a small wafer magnification correction amount. Accordingly, the exposure OL measurement results for the lower wafer LW5 may be worse than when the map correction value MCV1 is not applied. Similarly, the exposure OL measurement results of the lower wafer LW6 may be worse than when the map correction value MCV2 is not applied.

Further, in the bonding process of the subsequent lot, the wafer magnification is corrected in the case where the lower wafer LW5 and the upper wafer UW are bonded, and the case where the lower wafer LW6 and the upper wafer UW are bonded, respectively. The bond OL measurement results for the bonded wafer BW5, obtained by bonding the lower wafer LW5 to the upper wafer UW, are favorable because the map correction value MCV1 is used, which is suitable for the magnification correction amount of the exposure process of the lower wafer LW5, thus suppressing the overlay deviation of the random component. Similarly, the bond OL measurement results for the bonded wafer BW6, obtained by bonding the lower wafer LW6 to the upper wafer UW, are favorable because the map correction value MCV2 is used, which is suitable for the magnification correction amount of the exposure process of the lower wafer LW6, thus suppressing the overlay deviation of the random component.

As described above, the exposure apparatus 1 according to the first embodiment increases the overlay deviation in the exposure process, but can suppress the overlay deviation in the bonding process. Where the effect on the yield in concerned, there may be more cases of the bond OL deteriorating than cases where the exposure OL deteriorates. In contrast, the exposure apparatus 1 according to the first embodiment suitably permits an overlay deviation in a process for which the permissible overlay deviation range is wide (for example, in a pre-process exposure process), and thus suppresses an overlay deviation in a process for which the permissible overlay deviation range is narrow (for example, in a bonding process). As a result, the exposure apparatus 1 according to the first embodiment is capable of improving semiconductor device yield.

## <2> Second embodiment

A semiconductor manufacturing system PS according to a second embodiment has the same configuration as that of the first embodiment. In the second embodiment, the overlay deviation of the random component, which depends on the wafer magnification of a lower waver LW, is corrected using a method different from that of the first embodiment. Hereinafter, details of the semiconductor manufacturing system PS according to the second embodiment will be described.

## <2-1> Relationship between wafer magnification and polynomial regression coefficient

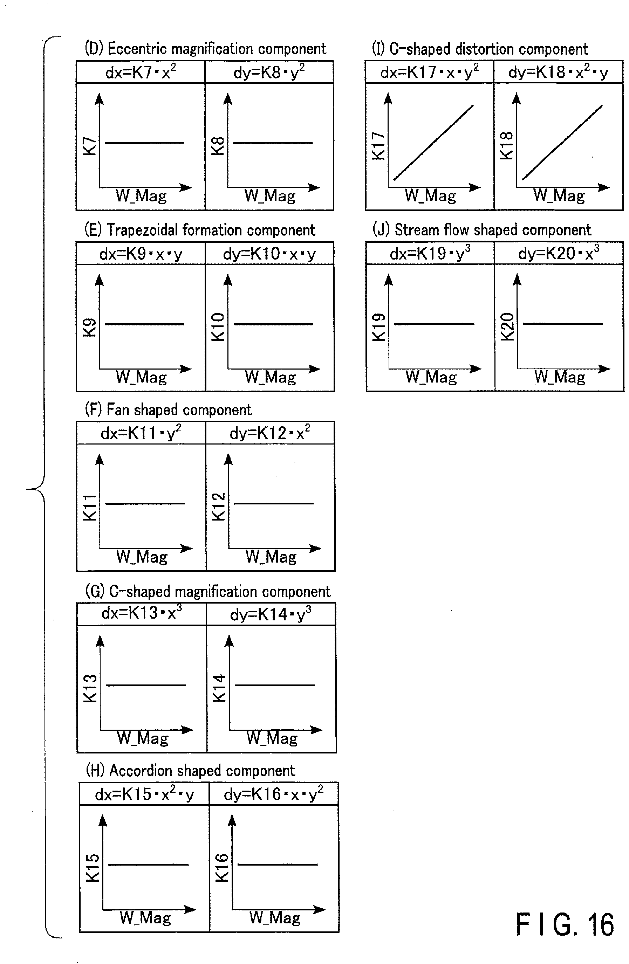

FIG. 16 is a diagram illustrating examples of the relationship between the wafer magnification and the polynomial regression coefficient pertaining to a bonded wafer BW that is manufactured by the semiconductor manufacturing system PS according to the second embodiment. The overlay deviation components illustrated in (D) to (J) of FIG. 16 correspond to the overlay deviation components illustrated in (D) to (J) of FIG. 2, respectively. In the graph illustrated in the frame of each overlay deviation component, the vertical axis represents the polynomial regression coefficients (K values), and the horizontal axis represents the wafer magnification correction values (W_Mag).

As illustrated in FIG. 16, in this example, none of K7 to K16, K19, and K20 has a strong sensitivity to the wafer magnification correction values. On the other hand, K17 and K18 have strong sensitivity to the wafer magnification correction values. That is, in the case of the bonded wafer BW of this example, the overlay deviation amount, which is based on K17 and K18 of the bond OL measurement, may change according to the magnitude of the wafer magnification of the lower wafer LW. Therefore, in the semiconductor manufacturing system PS according to the second embodiment, a relational expression between the polynomial regression coefficient (for example, K17 and K18) obtained through bond OL measurement, and the wafer magnification correction values is created and used for alignment in the exposure process.

## <2-2> Method of manufacturing semiconductor device

Hereinafter, an example of a specific process using the semiconductor manufacturing system PS will be described as a method for manufacturing a semiconductor device according to the second embodiment. That is, a semiconductor device is manufactured using the exposure method (exposure process) of the second embodiment described hereinbelow.

## <2-2-1> Method for creating correction formula

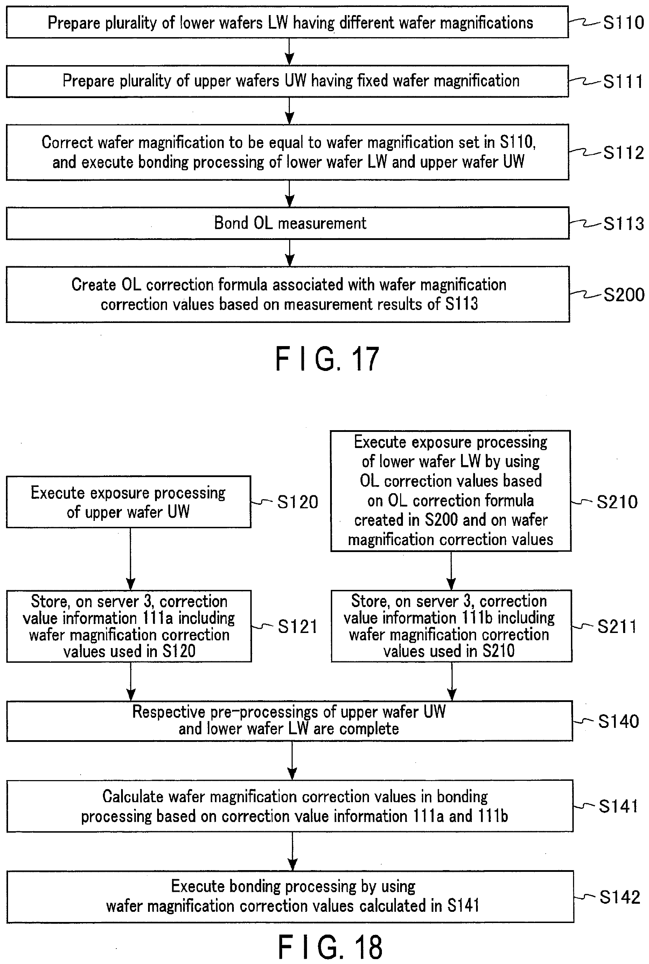

FIG. 17 is a flowchart illustrating an example of a method for creating OL correction values that are used by an exposure apparatus 1 according to the second embodiment. An example of a method for creating the OL correction formula will be described with reference to FIG. 17.

First, as in the first embodiment, the processes of S110 to S113 are executed. That is, a plurality of lower wafers LW exposed by changing the wafer magnification in a predetermined exposure process are prepared (S110). Further, a plurality of upper wafers UW exposed at a fixed wafer magnification in a predetermined exposure process are prepared (S111). Thereafter, the wafer magnification of the lower wafer LW is corrected so as to be equal to the wafer magnification set in S111, and a bonding process of the lower wafer LW and the upper wafer UW is executed (S112). Thereafter, bond OL measurement is executed (S113).

Next, the server 3 creates an OL (overlay) correction formula with which wafer magnification correction values and bond OL measurement results are associated with each other based on the bond OL measurement results in S113 (S200). Further, the OL correction formula thus created is stored in, for example, the storage device 11 of the exposure apparatus 1. The OL correction formula is a relational expression between wafer magnification correction values and predetermined K values. That is, by substituting wafer magnification correction values into the OL correction formula, the K values that can be used for alignment correction by the exposure apparatus 1 can be calculated. The predetermined K values are parameters that are dependent upon the wafer magnification in the bonding process, and are, for example, K17 and K18. The K values used in the OL correction formula are not limited to K17 and K18, and other K values may be used. In the second embodiment, it suffices that at least a K value having sensitivity to the wafer magnification correction values in the bond OL is used in the OL correction formula.

<2-2-2> Process flow from exposure process to bonding process

FIG. 18 is a flowchart illustrating an example of a process related to alignment correction of a random component in the semiconductor manufacturing system PS according to the second embodiment. Hereinafter, with reference to FIG. 18, differences, from the first embodiment, in the process flow from the exposure process to the bonding process in the second embodiment will be described.

In the second embodiment, the process relating to the exposure process in the pre-process of the lower wafer LW is different from that of the first embodiment. More specifically, the flowchart illustrated in FIG. 18 has a configuration in which S130 and S131 in the flowchart illustrated in FIG. 13 have been replaced with S210 and S211, respectively. That is, in the pre-process of the lower wafer LW, the processes of S210 and S211 are sequentially executed.

In the process of S210, the exposure process of the lower wafer LW is executed using alignment that is based on the OL correction formula created in S200 and on the wafer magnification correction values. More specifically, in the alignment correction process (S103 in FIG. 9), the exposure apparatus 1 according to the second embodiment calculates the wafer magnification correction values (for example, K3 and K4) using polynomial regression utilizing measurement results for the alignment marks AM in at least at three positions. K17, K18, and the like can also be calculated using this polynomial regression. Further, the exposure apparatus 1 corrects the K values (for example, K17 and K18) used for alignment correction within the wafer surface based on the calculated magnitude of the wafer magnification correction values. To correct the K values, the K values calculated by substituting the wafer magnification correction values into the OL correction formula are used. For example, K17 and K18, which are calculated based on the OL correction values, are used as offsets of the alignment correction values in the wafer surface. In this example, it suffices that the parameters of the K values used for alignment is changed based on at least the wafer magnification correction values obtained from the measurement results for the alignment marks AM.

In the process of S211, the correction value information 111b that includes the wafer magnification correction values used in S210 is stored on the server 3. When the processes of the respective pre-processings of the upper wafer UW and the lower wafer LW are complete (S140), the processes of S141 and S142 are executed as per the first embodiment. The other processes in the exposure apparatus 1 according to the second embodiment are similar to those of the first embodiment.

<2-3> Advantageous effects of second embodiment

In the case of the exposure apparatus 1 according to the second embodiment described hereinabove, although the overlay deviation increases due to the exposure process for pre-processing the lower wafer LW in the same manner as in the first embodiment, the overlay deviation can be suppressed between the upper wafer UW and lower wafer LW during the bonding process. As a result, the exposure apparatus 1 according to the second embodiment is capable of improving semiconductor device yield similarly to the first embodiment.

<2-4> Modification of second embodiment

In the second embodiment, a case has been exemplified where an alignment correction process is executed using a polynomial regression coefficient that is based on the wafer magnification, but the present invention is not limited thereto. A Zernike polynomial may also be used to create the OL correction formula. The Zernike polynomial is a function (orthogonal polynomial) that is defined inside a unit circle having a radius of "1". More specifically, the Zernike polynomial is expressed by, for example, Formula (1) below.
(Formula 1)

$$W(x,y) = \sum_{j=1}^{J} c_j Z_j(x,y) \qquad \cdots (1)$$

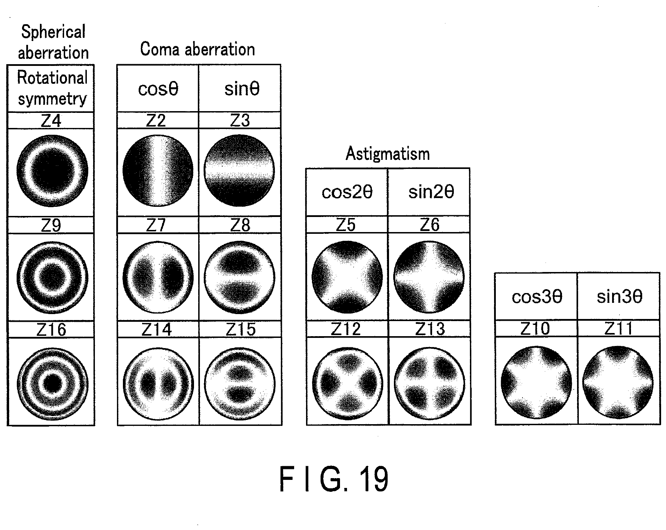

In Formula (1), "W(x, y)" indicates a wavefront at coordinates (x, y). "$Z_j$ (x, y)" indicates the j-th Zernike polynomial. "$c_j$" indicates a Zernike coefficient (that is, the coefficient of a Zernike polynomial) corresponding to a j-th Zernike polynomial. "J" indicates the number of Zernike polynomials used for expansion. The Zernike polynomial summation can (approximately) represent all surface shapes. FIG. 19 is a schematic diagram for describing the Zernike polynomials, and illustrates an image of the second to sixteenth Zernike polynomials. "Z2" is referred to as the tilt in the X direction, for example. "Z3" is referred to as the tilt in the Y direction, for example. "Z4" is referred to as defocus, for example. "Z5" is referred to as astigmatism, for example. "Z6" is referred to as oblique astigmatism, for example. "Z7" is referred to as X-direction coma aberration, for example. "Z8" is referred to as Y-direction coma aberration, for example. "Z9" is referred to as spherical aberration, for example. "Z10" is referred to as trefoil aberration in the X direction, for example. "Z11" is referred to as trefoil aberration in the Y direction, for example. "Z12" is referred to as second-order astigmatism, for example. "Z13" is referred to as second-order oblique astigmatism, for example. "Z14" is referred to as second-order X-direction coma aberration, for example. "Z15" is referred to as second-order Y-direction coma aberration, for example. "Z16" is referred to as second-order spherical aberration, for example.

In the exposure process, the exposure apparatus 1 according to the second embodiment is capable of acquiring information on the wavefront corresponding to the wafer surface and of executing a focus on the wafer (focusing) or the like. When Zernike polynomials are used in the second embodiment, the Zernike polynomials and the coefficients that have a high correlation with the wafer magnification correction values in the bonding process are used to create the OL correction formula. In this case, in the exposure process, the exposure apparatus 1 calculates the Zernike coefficient corresponding to the surface shape of the lower wafer LW based on measurement results for the wavefront aberration, the focus, and the like. Further, the exposure apparatus 1 may change the offset value in the alignment correction process based on the numerical value obtained by substituting the predetermined Zernike coefficient into the OL correction formula. It suffices that the exposure apparatus 1 calculates the offset value using an OL correction formula that is based on at least the surface shape of the lower wafer LW and the alignment results, and uses the offset value in the alignment correction process.

<3> Third embodiment

A third embodiment relates to a specific example of a semiconductor device to which the method for manufacturing a semiconductor device described in the first and second embodiments can be applied. Hereinafter, as a specific example of the semiconductor device, a memory device 4, which is a NAND flash memory, will be described.

<3-1> Configuration

<3-1-1> Configuration of memory device 4

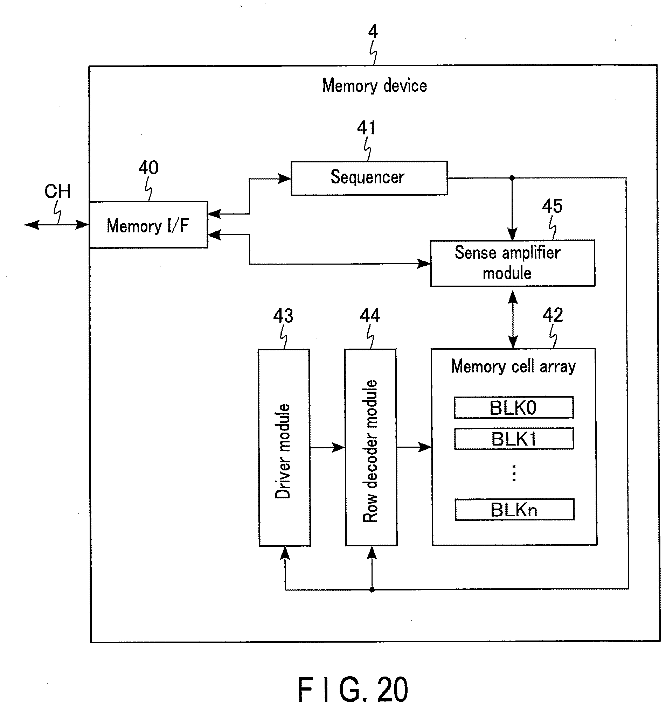

FIG. 20 is a block diagram illustrating an example of a configuration of the memory device 4 according to the third embodiment. As illustrated in FIG. 20, the memory device 4 includes, for example, a memory interface (memory I/F) 40, a sequencer 41, a memory cell array 42, a driver module 43, a row decoder module 44, and a sense amplifier module 45.

The memory I/F 40 is a hardware interface connected to an external memory controller. The memory I/F 40 performs communication according to an interface standard between the memory device 4 and the memory controller. The memory I/F 40 supports, for example, the NAND interface standard.

The sequencer 41 is a control circuit that controls the whole operation of the memory device 4. The sequencer 41 controls the driver module 43, the row decoder module 44, the sense amplifier module 45, and the like based on commands received via the memory I/F 40 to execute a read operation, a write operation, an erase operation, and the like.

The memory cell array 42 is a storage circuit that includes a set of a plurality of memory cells. The memory cell array 42 includes a plurality of blocks BLK0 to BLKn (n is an integer of 1 or more). The block BLK is used, for example, as a data erase unit. A plurality of bit lines and a plurality of word lines are also provided in the memory cell array 42. Each memory cell is associated with, for example, one bit line and one word line. Each memory cell is identified based on an address identifying a word line WL and an address identifying a bit line BL.

The driver module 43 is a driver circuit that generates a voltage which is used in a read operation, a write operation, an erase operation, and the like. The driver module 43 is connected to the row decoder module 44 via a plurality of signal lines. The driver module 43 is capable of changing the voltage applied to each of the plurality of signal lines based on a page address received via the memory I/F 40.

The row decoder module 44 is a decoder that decodes row addresses received via the memory I/F 40. The row decoder module 44 selects one block BLK based on the decoding results. Further, the row decoder module 44 transfers the voltages applied to the plurality of signal lines to the plurality of wirings (word lines WL and the like) that are provided to the selected block BLK.

The sense amplifier module 45 is a sense circuit that, in a read operation, senses data which is read from the selected block BLK based on the voltage of the bit line BL. The sense amplifier module 45 transmits the read data to the memory controller via the memory I/F 40. Further, in a write operation, the sense amplifier module 45 is capable of applying, to each bit line BL, a voltage which corresponds to the data to be written to the memory cell.

<3-1-2> Circuit configuration of memory cell array 42

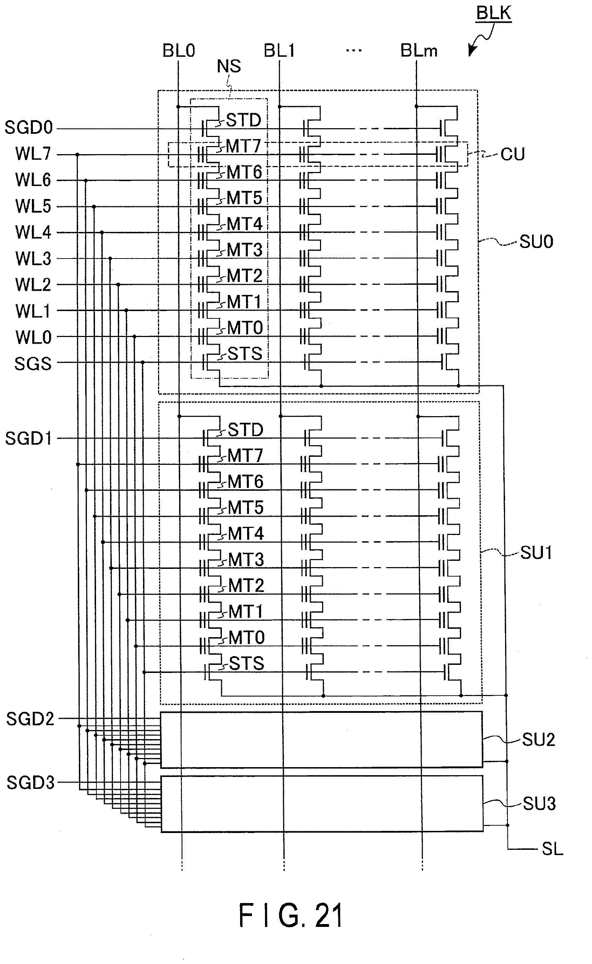

FIG. 21 is a circuit diagram illustrating an example of a circuit configuration of the memory cell array 42 included in the memory device 4 according to the third embodiment. FIG. 21 illustrates one block BLK among the plurality of blocks BLK included in the memory cell array 42. As illustrated in FIG. 21, the block BLK includes, for example, string units SU0 to SU3.

Each string unit SU includes a plurality of NAND strings NS. The NAND strings NS are associated with bit lines BL0 to BLm (m is an integer of 1 or more), respectively. Different column addresses are allocated to the bit lines BL0 to BLm, respectively. Each bit line BL is shared by the NAND string NS to which the same column address is allocated among the plurality of blocks BLK. Each NAND string NS includes, for example, memory cell transistors MT0 to MT7 and select transistors STD and STS.

Each memory cell transistor MT includes a control gate and a charge storage layer, and stores data in a nonvolatile manner. The memory cell transistors MT0 to MT7 of each NAND string NS are connected in series. The control gates of the memory cell transistors MT0 to MT7 are connected to the word lines WL0 to WL7, respectively. Each of the word lines WL0 to WL7 is provided for each block BLK. A set of plural memory cell transistors MT connected to the common word line WL in the same string unit SU is referred to as, for example, "cell unit CU". When each memory cell transistor MT stores 1-bit data, the cell unit CU stores "1-page data". The cell unit CU may have a storage capacity of two page data or more according to the number of bits of data stored by the memory cell transistor MT.

Each of the select transistors STD and STS is used to select the string unit SU. The drain of the select transistor STD is connected to the associated bit line BL. The source of the select transistor STD is connected to one end of the memory cell transistors MT0 to MT7 connected in series. Gates of the select transistors STD included in the string units SU0 to SU3 are connected to select gate lines SGD0 to SGD3, respectively. The drain of the select transistor STS is connected to the other ends of the memory cell transistors MT0 to MT7 connected in series. The source of the select transistor STS is connected to the source line SL. The gate of the select transistor STS is connected to the select gate line SGS. The source line SL is shared by a plurality of blocks BLK, for example.

<3-1-3> Structure of memory device 4

Hereinafter, an example of the structure of the memory device 4 according to the third embodiment will be described. Note that, in the third embodiment, the X direction corresponds to the direction of extension of the word lines WL, the Y direction corresponds to the direction of extension of the bit lines BL, and the Z direction corresponds to the direction perpendicular to the surface of the semiconductor substrate used to form the memory device 4.

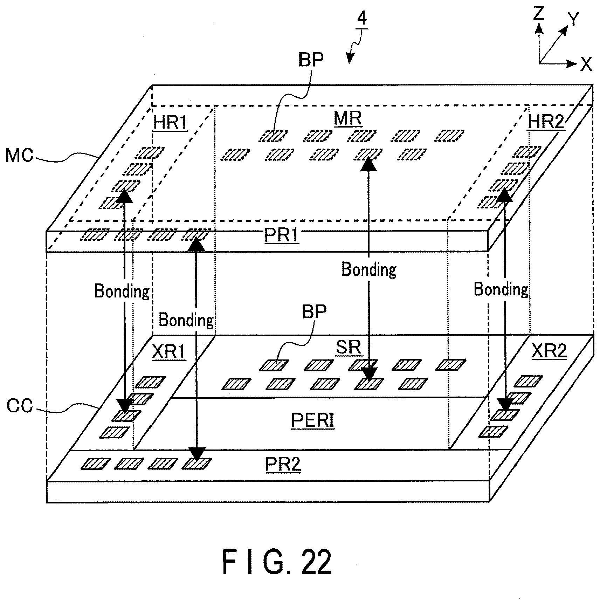

FIG. 22 is a perspective view illustrating an example of the structure of the memory device 4 according to the third embodiment. As illustrated in FIG. 22, the memory device 4 includes a memory chip MC and a CMOS chip CC. The lower surface of the memory chip MC corresponds to the surface of the lower wafer LW. The upper surface of the CMOS chip CC corresponds to the surface of the upper wafer UW. The memory chip MC includes, for example, a memory region MR, hookup regions HR1 and HR2, and a pad region PR1. The CMOS chip CC includes, for example, a sense amplifier region SR, a peripheral circuit region PERI, transfer regions XR1 and XR2, and a pad region PR2.

The memory region MR includes a memory cell array 42. The hookup regions HR1 and HR2 include wiring or the like that is used for interconnecting the stacked wiring provided to the memory chip MC, and the row decoder module 44 provided to the CMOS chip CC. The pad region PR1 includes a pad or the like that is used for a connection between the memory device 4 and the memory controller. The hookup regions HR1 and HR2 sandwich the memory region MR in the X direction. The pad region PR1 is adjacent, in the Y direction, to the memory region MR and the hookup regions HR1 and HR2, respectively.

The sense amplifier region SR includes a sense amplifier module 45. The peripheral circuit region PERI includes a sequencer 41, a driver module 43, and the like. The transfer regions XR1 and XR2 include a row decoder module 44. The pad region PR2 includes a memory I/F 40. The sense amplifier region SR and the peripheral circuit region PERI are arranged adjacent to each other in the Y direction and overlap the memory region MR. The transfer regions XR1 and XR2 sandwich a set of the sense amplifier region SR and the peripheral circuit region PERI in the X direction, and overlap the hookup regions HR1 and HR2, respectively. The pad region PR2 overlaps the pad region PR1 of the memory chip MC.

The memory chip MC includes a plurality of attachment pads BP below the memory region MR, the hookup regions HR1 and HR2, and the pad region PR1, respectively. The attachment pads BP of the memory region MR are connected to the associated bit lines BL. The attachment pads BP of the hookup regions HR are connected to associated wiring (for example, word lines WL) among the stacked wiring provided to the memory region MR. The attachment pad BP of the pad region PR1 is connected to a pad (not illustrated) provided to the upper surface of the memory chip MC. The pad provided to the upper surface of the memory chip MC is used, for example, for a connection between the memory device 4 and the memory controller.

The CMOS chip CC includes a plurality of attachment pads BP above the sense amplifier region SR, the peripheral circuit region PERI, the transfer regions XR1 and XR2, and the pad region PR2, respectively. The attachment pad BP of the sense amplifier region SR overlaps the attachment pad BP of the memory region MR. The attachment pads BP of the transfer regions XR1 and XR2 overlap the attachment pads BP of the hookup regions HR1 and HR2, respectively. The attachment pad BP of the pad region PR1 overlaps the attachment pad BP of the pad region PR2.

The memory device 4 has a structure in which the lower surface of the memory chip MC and the upper surface of the CMOS chip CC are bonded to each other. Among the plurality of attachment pads BP provided to the memory device 4, two attachment pads BP facing each other between the memory chip MC and the CMOS chip CC are electrically connected through bonding. Thus, the circuit in the memory chip MC and the circuit in the CMOS chip CC are electrically interconnected via the attachment pads BP. A set of two attachment pads BP facing each other between the memory chip MC and the CMOS chip CC may have a boundary or may be integrated with one another.

(Planar layout of memory cell array 42)

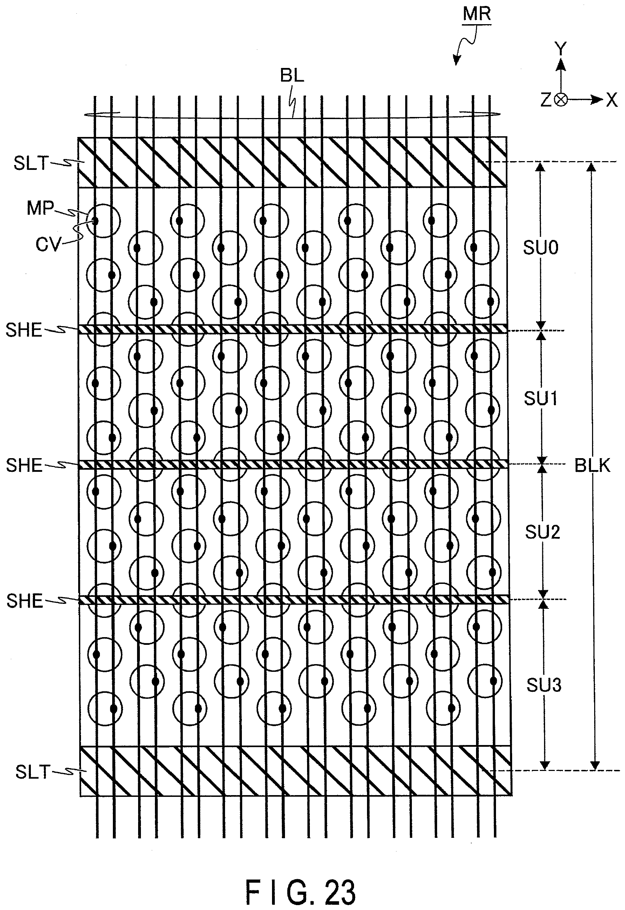

FIG. 23 is a plan view illustrating an example of a planar layout of a memory cell array 42 included in the memory device 4 according to the third embodiment. FIG. 23 illustrates an area that includes one block BLK in the memory region MR. As illustrated in FIG. 23, the memory device 4 includes, for example, a plurality of slits SLT, a plurality of slits SHE, a plurality of memory pillars MP, a plurality of bit lines BL, and a plurality of contacts CV. In the memory region MR, a planar layout described below is repeatedly arranged in the Y direction.

Each slit SLT has, for example, a structure in which an insulating member is embedded. Each slit SLT insulates adjacent wirings (for example, the word lines WL0 to WL7 and the select gate lines SGD and SGS) via the slit SLT. Each slit SLT has a portion that is provided so as to extend along the X direction and that crosses the memory region MR and the hookup regions HR1 and HR2, along the X direction. The plurality of slits SLT are arranged in the Y direction. The regions that are delimited by the slits SLT correspond to the blocks BLK.

Each slit SHE has, for example, a structure in which an insulating member is embedded. The slits SHE insulate adjacent wirings (at least select gate line SGD) from each other via the slits SLT. Each slit SHE has a portion that is provided so as to extend along the X direction and that crosses the memory region MR. The plurality of slits SHE are arranged in the Y direction. In this example, three slits SHE are arranged between adjacent slits SLT. The plurality of regions partitioned by the slits SLT and SHE correspond to the string units SU0 to SU3, respectively.

Each memory pillar MP functions as, for example, one NAND string NS. The plurality of memory pillars MP are arranged in a staggered manner of, for example, 19 rows in a region between two adjacent slits SLT. Further, one slit SHE overlaps the memory pillar MP of the fifth column, the memory pillar MP of the 10 column, and the memory pillar MP of the 15 column, respectively, from the upper side of the paper surface.

Each of the bit lines BL has a portion that is provided so as to extend along the Y direction, and that crosses a region where the plurality of blocks BLK are provided, along the Y direction. The plurality of bit lines BL are arranged in the X direction. Each bit line BL is arranged so as to overlap at least one memory pillar MP, for each string unit SU. In this example, two bit lines BL overlap each memory pillar MP.

Each contact CV is provided between one bit line BL among the plurality of bit lines BL overlapping the memory pillar MP, and the memory pillar MP. The contact CV electrically interconnects the memory pillar MP and the bit line BL. Note that the contact CV between the memory pillar MP overlapping the slit SHE and the bit line BL is omitted.

(Cross-sectional structure of memory cell array 42)

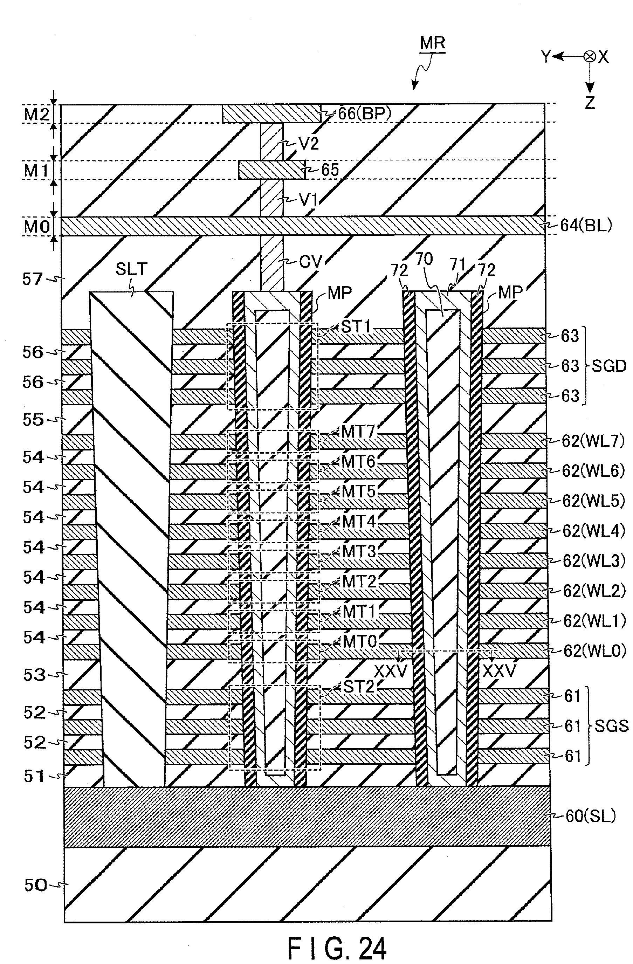

FIG. 24 is a cross-sectional view illustrating an example of a cross-sectional structure of a memory cell array 42 included in the memory device 4 according to the third embodiment. FIG. 24 illustrates a cross-section, taken along the Y direction, that includes the memory pillar MP and the slit SLT in the memory region MR. Note that the Z direction in FIG. 24 refers to the lower side of the paper surface, but in the description of FIG. 24, the upper side of the paper surface is referred to as "up", and the lower side of the paper surface is referred to as "down". As illustrated in FIG. 24, the memory device 4 includes, for example, insulating layers 50 to 57, conductive layers 60 to 66, and contacts V1 and V2.

The insulating layer 50 is provided, for example, in the lowermost layer of the memory chip MC. The conductive layer 60 is provided on the insulating layer 50. The insulating layer 51 is provided on the conductive layer 60. The conductive layer 61 and the insulating layer 52 are alternately provided on the insulating layer 51. The insulating layer 53 is provided on the uppermost conductive layer 61. The conductive layer 62 and the insulating layer 54 are alternately provided on the insulating layer 53. The insulating layer 55 is provided on the uppermost conductive layer 62. The conductive layer 63 and the insulating layer 56 are alternately provided on the insulating layer 55. The insulating layer 57 is provided on the uppermost conductive layer 63. The conductive layer 64 is provided on the insulating layer 57. The contact V1 is provided on the conductive layer 64. The conductive layer 65 is provided on the contact V1. The contact V2 is provided on the conductive layer 65. The conductive layer 66 is provided on the contact V2. Hereinafter, the wiring layers provided with the conductive layers 64, 65, and 66 are referred to as "M0", "M1", and "M2", respectively.

Each of the conductive layers 60, 61, 62, and 63 is formed in, for example, a plate shape that extends along the XY plane. The conductive layer 64 is formed in, for example, a line shape that extends in the Y direction. The conductive layers 60, 61, and 63 are used as a source line SL, a select gate line SGS, and a select gate line SGD, respectively. The plurality of conductive layers 62 are used as the word lines WL0 to WL7, respectively, in order from the conductive layer 60 side. The conductive layer 64 is used as the bit line BL. The contacts V1 and V2 are provided in a columnar shape. The conductive layers 64 and 65 are interconnected via the contact V1. The conductive layer 65 and the conductive layer 66 are interconnected via a contact V2. The conductive layer 65 is, for example, wiring formed in a line shape that extends in the X direction. The conductive layer 66 is in contact with the interface of the memory chip MC and is used as an attachment pad BP. The conductive layer 66 contains copper, for example.

The slit SLT has a portion formed in a plate shape that extends along the XZ plane, and divides the insulating layers 51 to 56 and the conductive layers 61 to 63. Each memory pillar MP is provided so as to extend along the Z direction, and penetrates the insulating layers 51 to 56 and the conductive layers 61 to 63. Each memory pillar MP includes, for example, a core member 70, a semiconductor layer 71, and a stacked film 72. The core member 70 is an insulator provided so as to extend along the Z direction. The semiconductor layer 71 covers the core member 70. A lower portion of the semiconductor layer 71 is in contact with the conductive layer 60. The stacked film 72 covers the lateral surface of the semiconductor layer 71. The contact CV is provided on the semiconductor layer 71. The conductive layer 64 is in contact with the top of contact CV.

Note that, in the illustrated region, the contact CV corresponding to one memory pillar MP of the two memory pillars MP is illustrated. The contacts CV are connected in a region (not illustrated) to the memory pillar MP to which the contacts CV are not connected in the region. A portion where the memory pillar MP intersects the plurality of conductive layers 61 functions as the select transistor STS. The portion where the memory pillar MP intersects the conductive layer 62 functions as the memory cell transistor MT. The portion where the memory pillar MP intersects the plurality of conductive layers 63 functions as the select transistor STD.

(Cross-sectional structure of memory pillar MP)

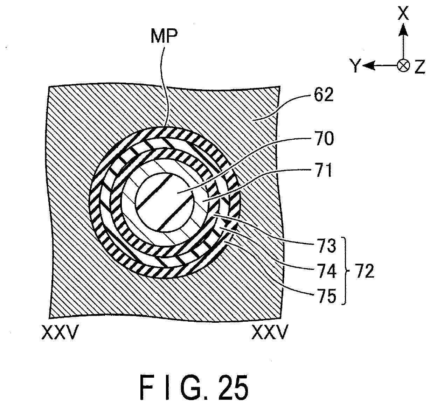

FIG. 25 is a cross-sectional view taken along line XXV-XXV in FIG. 24, illustrating an example of a cross-sectional structure of a memory pillar MP included in the memory device 4 according to the third embodiment. FIG. 25 illustrates a cross-section that includes the memory pillar MP and the conductive layer 62 and that runs parallel to the conductive layer 60. As illustrated in FIG. 25, the stacked film 72 includes, for example, a tunnel insulating film 73, an insulating film 74, and a block insulating film 75.

The core member 70 is provided, for example, at the center portion of the memory pillar MP. The semiconductor layer 71 surrounds the lateral surface of the core member 70. The tunnel insulating film 73 surrounds the lateral surface of the semiconductor layer 71. The insulating film 74 surrounds the lateral surface of the tunnel insulating film 73. The block insulating film 75 surrounds the lateral surface of the insulating film 74. The conductive layer 62 surrounds the lateral surface of the block insulating film 75. The semiconductor layer 71 is used as a channel (current path) of the memory cell transistors MT0 to MT7 and the select transistors STD and STS. Each of the tunnel insulating film 73 and the block insulating film 75 contains, for example, silicon oxide. The insulating film 74 is used as the charge storage layer of the memory cell transistor MT, and includes, for example, silicon nitride. As a result, each of the memory pillars MP functions as one NAND string NS.

(Cross-sectional structure of memory device 4)

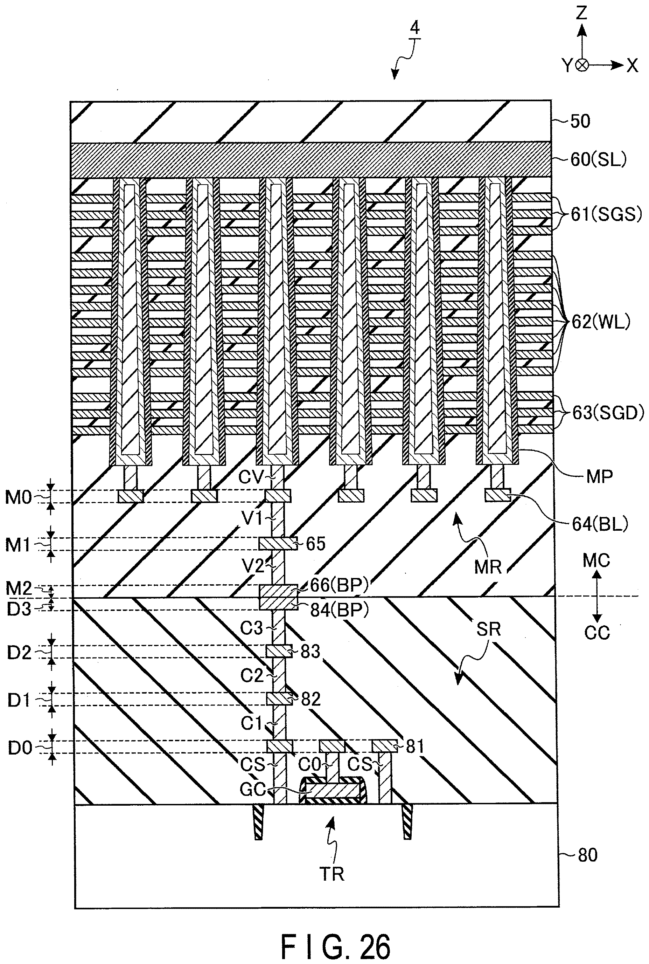

FIG. 26 is a cross-sectional view illustrating an example of a cross-sectional structure of a memory device 4 according to the third embodiment. FIG. 26 illustrates a cross-section that includes the memory region MR and the sense amplifier region SR, that is, a cross-section including the memory chip MC and the CMOS chip CC. As illustrated in FIG. 26, the memory device 4 includes a semiconductor substrate 80, conductive layers GC and 81 to 84, and contacts CS and C0 to C3 in the sense amplifier region SR.

The semiconductor substrate 80 is a substrate that is used to form the CMOS chip CC. The semiconductor substrate 80 includes a plurality of well regions (not illustrated). For example, a transistor TR is formed in each of the plurality of well regions. The plurality of well regions are separated by shallow trench isolation (STI), for example. A conductive layer GC is provided on the semiconductor substrate 80 via a gate insulating film. The conductive layer GC in the sense amplifier region SR is used as a gate electrode of the transistor TR included in the sense amplifier module 45. The contact C0 is provided on the conductive layer GC. Two contacts CS are provided on the semiconductor substrate 80 in correspondence with the source and the drain of the transistor TR.

The conductive layer 81 is provided on the contact CS and the contact C0, respectively. The contact C1 is provided on the conductive layer 81. The conductive layer 82 is provided on the contact C1. The conductive layers 81 and 82 are electrically interconnected via the contact C1. The contact C2 is provided on the conductive layer 82. The conductive layer 83 is provided on the contact C2. The conductive layers 82 and 83 are electrically interconnected via the contact C2. The contact C3 is provided on the conductive layer 83. The conductive layer 84 is provided on the contact C3. The conductive layers 83 and 84 are electrically connected via the contact C3. Hereinafter, the wiring layers on which the conductive layers 81 to 84 are provided are referred to as "D0", "D1", "D2", and "D3", respectively.

The conductive layer 84 is in contact with the interface of the CMOS chip CC and is used as an attachment pad BP. The conductive layer 84 in the sense amplifier region SR is bonded to the conductive layer 66 (that is, the attachment pad BP of the memory chip MC) in the memory region MR that is arranged to face the conductive layer 84. Further, each conductive layer 84 in the sense amplifier region SR is electrically connected to one bit line BL. The conductive layer 84 contains copper, for example.

In the memory device 4, the wiring layer D3 of the CMOS chip CC and the wiring layer M2 of the memory chip MC are adjacent to each other due to the memory chip MC and the CMOS chip CC being bonded to each other. The semiconductor substrate 80 corresponds to the back surface side of the upper wafer UW, and the wiring layer D3 corresponds to the front surface side of the upper wafer UW. The insulating layer 50 corresponds to the back surface side of the lower wafer LW, and the wiring layer M2 corresponds to the front surface side of the lower wafer LW. The semiconductor substrate, which is used to form the memory chip MC, is removed along with processes such as pad formation after the bonding process.

<3-2> Advantageous effects of third embodiment

As described hereinabove, the memory device 4 includes, for example, the memory chip MC, which includes a structure in which memory cells are three-dimensionally stacked, and the CMOS chip CC, which includes other control circuits and the like. In the memory chip MC and the CMOS chip CC, the variation in wafer magnification tends to be larger between the wafers in the memory chip MC. More specifically, because the memory chip MC includes the memory cell array 42 formed in a high layer, the variation in the amount of warpage of the wafer increases, and the variation in wafer magnification may increase. On the other hand, the arrangement of the shots of the CMOS chip CC is close to an ideal lattice that is based on the exposure apparatus. Therefore, when the bonding process is executed, the wafer whereon the memory chip MC is formed is preferably allocated to the lower wafer LW that enables wafer magnification to be corrected, and the wafer whereon the CMOS chip CC is formed is preferably allocated to the upper wafer UW. Thus, the first and second embodiments each enable the yield of the memory device 4 to be improved.

<4> Fourth Embodiment

A semiconductor manufacturing system PS according to a fourth embodiment has a configuration similar to that of the first embodiment. In the fourth embodiment, the overlay deviation of a random component, which depends on the amount of warpage of the upper wafer UW, is corrected using a method similar to that of the first embodiment. The semiconductor manufacturing system PS according to the fourth embodiment will be described in detail below.

<4-1> Method for manufacturing semiconductor device

Hereinafter, as a method for manufacturing a semiconductor device according to the fourth embodiment, an example of a specific process using the exposure apparatus 1 will be described. That is, a semiconductor device is manufactured using the exposure method (exposure process) of the first embodiment described hereinbelow.

<4-1-1> Method for creating map correction values

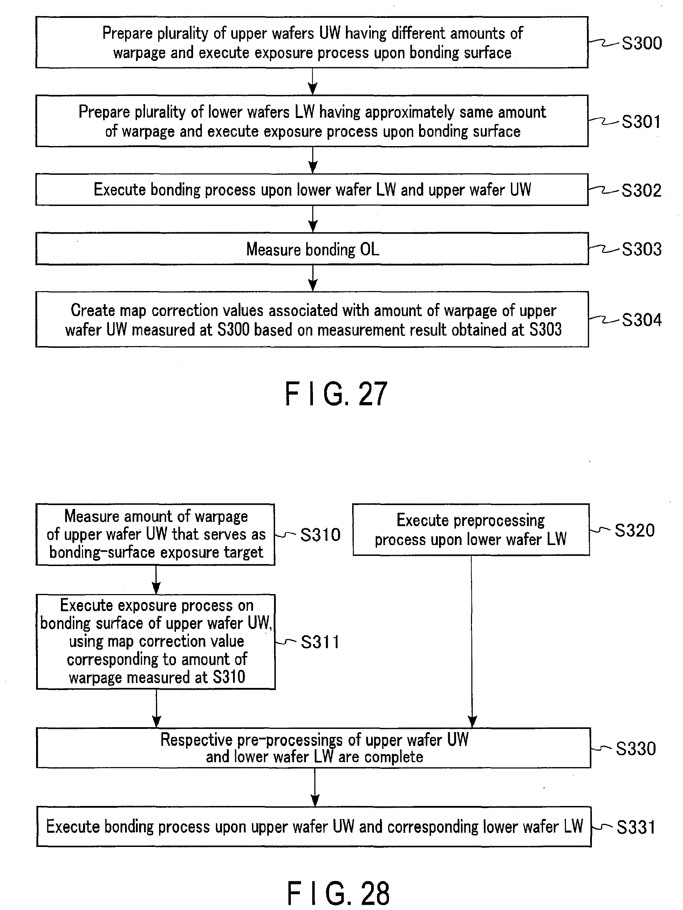

FIG. 27 is a flowchart illustrating an example of a method for creating map correction values that are used by the exposure apparatus 1 according to the first embodiment. Hereinafter, an example of the method for creating map correction values will be described with reference to FIG. 27.

First, a plurality of upper wafers UW having different amounts of warpage are prepared, upon each of which an exposure process is executed (S300). That is, in the process in S300, two or more upper wafers UW that have different amounts of warpage are prepared. The exposure process in S300 corresponds to a bonding-surface exposure process for the upper wafers UW.

Next, a plurality of lower wafers LW having approximately the same amount of warpage are prepared, upon each of which an exposure process is executed (S301). That is, in the process in S301, two or more lower wafers LW that have approximately the same amount of warpage are prepared. The exposure process in S301 corresponds to the bonding-surface exposure process for the lower wafers LW.

Next, a bonding process is executed upon the lower wafers LW and upper wafers UW (S302). In this manner, a plurality of bonded wafers BW incorporating the upper wafers UW, whose amounts of warpage differ from each other, are formed.

Next, bond OL measurement is executed (S303). Through this bond OL measurement, the bond OL measurement results are obtained for each amount of warpage pertaining to the upper wafers UW set in the process of S300. The bond OL measurement results are stored on the server 3, for example.

Next, the server 3 creates, based on the bond OL measurement results obtained in the process of S303, map correction values in which the amounts of warpage of the wafers and the bond OL measurement results are associated with each other (S304). Further, the plurality of map correction values thus created are stored in the storage device 11 of the exposure apparatus 1 as the map correction value set 112. Each of the map correction values is associated with, for example, a respective one of the amounts of warpage of the wafers in certain ranges that differ from each other. A certain range is set as a reference for the amounts of warpage of the wafers set in S300, for example.

Even if the lower wafers LW have different amounts of warpage, this will have a small effect upon the map correction values created in S304. The amounts of warpage therefore may differ from each other among the lower wafers LW prepared in the process of S301.

<4-1-2> Process flow from exposure process to bonding process

FIG. 28 is a flowchart illustrating an example of a process related to alignment correction of a random component in the semiconductor manufacturing system PS according to the fourth embodiment. Hereinafter, the process flow from the exposure process to the bonding process of the fourth embodiment will be described with reference to FIG. 28.

First, the amount of warpage of an upper wafer UW, which is the bonding-surface exposure target, is measured (S310). The data of the amount of warpage of the upper wafer UW is transferred, for example, to the exposure apparatus 1 via the server 3, and stored in the storage device 11 of the exposure apparatus 1.

Next, an exposure process is executed on the bonding surface of the upper wafer UW, using a map correction value corresponding to the measured amount of warpage (S311). For example, the exposure apparatus 1 selects, as a map correction value to be applied to a wafer having a large amount of warpage, a map correction value created based on the bond OL measurement results of a bonded wafer BW obtained using an upper wafer UW with a large amount of warpage. The exposure apparatus 1 further selects, as a map correction value to be applied to a wafer having a small amount of warpage, a map correction value created based on the bond OL measurement results of a bonded wafer BW obtained using an upper wafer UW with a small amount of warpage.

In parallel with the processes in S310 and S311, a pre-processing is executed on the lower wafer LW (S320). As a result, a lower wafer LW is formed.

After the respective pre-processings of the upper wafer UW and the lower wafer LW are completed (in other words, the pre-processing upon each of the upper wafer UW and lower wafer LW that are associated with each other is completed) (S330), a bonding process is executed (S331). In this manner, a bonded wafer BW is formed in which the associated upper wafer UW and lower wafer LW are bonded to each other.

Note that, if there is no map correction value associated with the amount of warpage, the exposure apparatus 1 may use a map correction value associated with an amount of warpage close to the amount of warpage of this wafer, or may use a map correction value calculated based on a combination of a plurality of map correction values. Moreover, the exposure apparatus 1 or the server 3 may create, for each shot, a relational expression between the amounts of warpage of a wafer and the overlay correction values based on a plurality of combinations of the amounts of warpage and the map correction values so that map correction values which are based on this relational expression can be used in the exposure process.

<4-2> Advantageous effects of fourth embodiment

In a semiconductor device formed by bonding two wafers, an overlay deviation of a random component may occur in the bond overlay (OL) in accordance with an amount of warpage of the upper wafer UW. One of the factors responsible for this may be a stress applied to the upper wafer UW during the bonding process, which may vary in accordance with the amount of warpage of the upper wafer UW. If the stress applied to the upper wafer UW varies, the stress on the upper wafer UW at the time of the upper wafer UW coming off the upper stage 233 and falling upon the lower wafer LW may vary during the bonding process, which may produce an overlay deviation. As a method for suppressing such an overlay deviation of the random component in a bonded wafer BW, an exposure map correction that can improve the bond OL may be used in a predetermined exposure process of the pre-processing.

Here, an example of a method for improving a bond overlay according to the fourth embodiment will be described using a second comparative example. In this example, it is assumed that the variation in the amounts of warpage of the lower wafers LW is small in the pre-processing and that the variation in the amounts of warpage of the upper wafers UW is large in the pre-process.

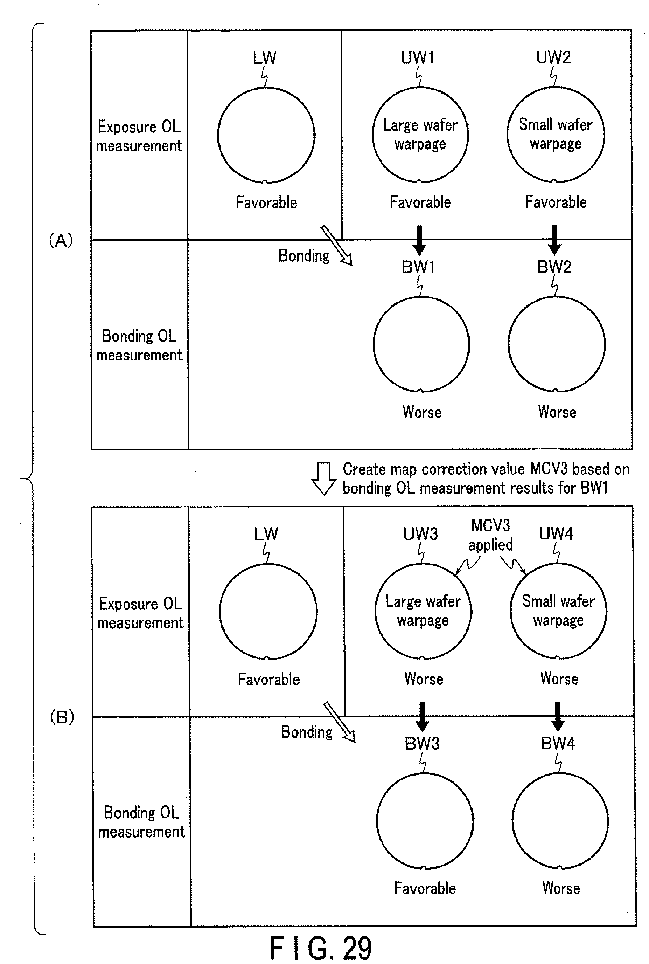

FIG. 29 is a schematic diagram illustrating an example of a method for improving a bond overlay in the second comparative example. (A) and (B) of FIG. 29 correspond to before and after applying the exposure map correction, respectively, and illustrate the respective results of the exposure OL measurement and bond OL measurement in the bonding surface of the lot. Note that it is assumed that the overlay in the exposure OL of the lower wafer LW is favorable both before and after applying the exposure map correction.

As illustrated in (A) of FIG. 29, in the pre-process exposure process, the upper wafer UW1 has a large amount of warpage, and the upper wafer UW2 has a small amount of warpage. In the exposure OL measurement of each of the upper wafers UW1 and UW2, the overlay is favorable. Through the bonding process, bonded wafers BW1 and BW2 are formed, using the upper wafers UW1 and UW2, respectively. In this example, the overlay deviation of the random component, which is based on the correction of the amount of warpage in the bonding process, remains for the bonded wafer BW1 obtained by bonding the upper wafer UW1 and a lower wafer LW, and the bonded wafer BW2 obtained by bonding the upper wafer UW2 and a lower wafer LW, respectively. Therefore, in the bond OL measurement of each of the bonded wafers BW1 and BW2, the overlay is unfavorable.

In the second comparative example, a map correction value MCV3 is created based on the bond OL measurement results for the bonded wafer BW1, and this map correction value MCV3 is used for the process of subsequent lots. Thereupon, as illustrated in (B) of FIG. 29, in the exposure OL measurement of the subsequent lots, the exposure OL of the upper wafer UW3 having a large amount of warpage and the exposure OL of the upper wafer UW4 having a small amount of warpage both may be worsened by applying the map correction value MCV3. This is because the use of map correction values that can improve the overlay of the bonding process may cause an overlay deviation between the pattern formed by the exposure process and the substrate pattern. Because the map correction value MCV3 is used in the exposure process of the upper wafer UW3, the overlay deviation of the random component may be suppressed, and the bond OL measurement results for the bonded wafer BW3 obtained by bonding the upper wafer UW3 and the lower wafer LW may become favorable.

However, the overlay deviation tendency of the random component may change according to the amount of warpage of the upper wafer UW. In the bonded wafer BW4 obtained by bonding the upper wafer UW4 to a lower wafer LW, the map correction value MCV3 corresponding to a "large amount of warpage" is used even though the amount of warpage of the wafer is small in the exposure process. This may worsen the improvement amount of the overlay deviation of the random component than in the bonded wafer BW3. As indicated in this example, the tendency of the map of the overlay may produce differences depending on the amount of warpage in the upper wafer UW. As a result, the improvement amount of the overlay may decrease depending on the amount of warpage of the upper wafer UW in the second comparative example.

The exposure apparatus 1 according to the fourth embodiment has a function for selecting a map correction value MCV to be used in the exposure process for the bonding surface of the upper wafer UW in accordance with the amount of warpage of the upper wafer UW.

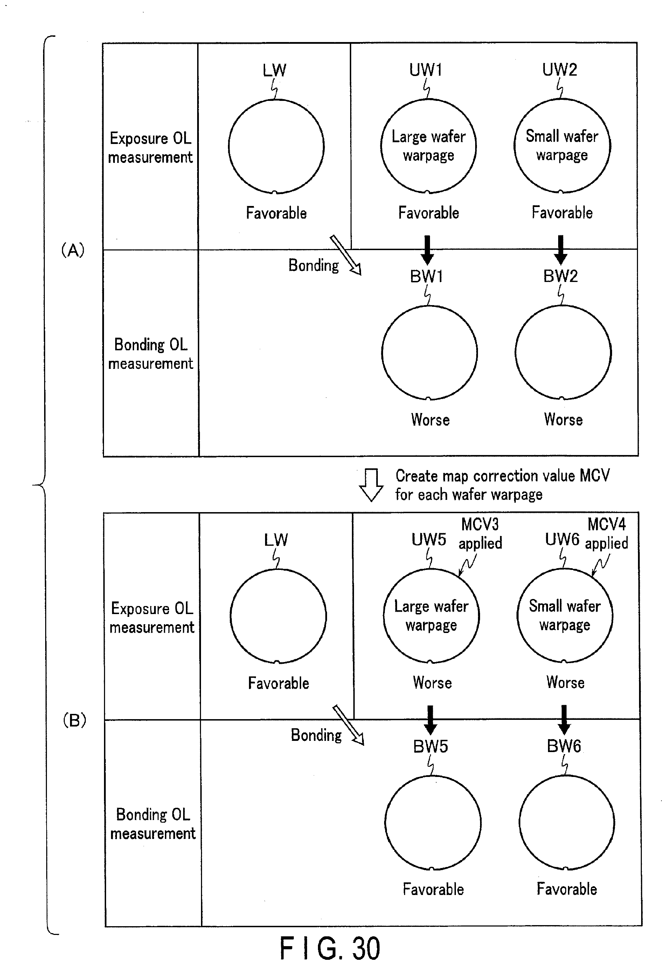

FIG. 30 is a schematic diagram illustrating examples of a method for improving a bond overlay according to the fourth embodiment. (A) and (B) of FIG. 30 correspond to before and after applying the exposure map correction of the fourth embodiment, respectively, and illustrate the respective results of the exposure OL measurement and bond OL measurement in the bonding surface of a lot. Note that it is assumed that the overlay in the exposure OL of the upper wafer UW is favorable before and after applying the exposure map correction, respectively. As illustrated in (A) of FIG. 30, an example before application of the exposure map correction of the fourth embodiment is similar to an example before application of the exposure map correction of the second comparative example.

In the fourth embodiment, a map correction value MCV3 is created based on the amount of warpage of the upper wafer UW1 measured before the exposure process upon the bonding surface of the upper wafer UW1, and the bond OL measurement result of the bonded wafer BW1. Similarly, a map correction value MCV4 is created based on the amount of warpage of the upper wafer UW2 measured before the exposure process upon the bonding surface of the upper wafer UW2 and the bond OL measurement result of the bonded wafer BW2. Further, the map correction values MCV3 and MCV4 are each stored in the storage device 11 of the exposure apparatus 1 as the map correction value set 112. Thereafter, the map correction value set 112 is used for the process of subsequent lots.

Thereupon, as illustrated in (B) of FIG. 30, in the exposure process of the subsequent lots in the fourth embodiment, a map correction value MCV corresponding to the amount of warpage of the upper wafer UW is used. More specifically, the map correction value MCV3 associated with a "large amount of warpage" is applied to an upper wafer UW5 having a large amount of warpage. The map correction value MCV4 associated with a "small amount of warpage" is applied to an upper wafer UW6 having a small amount of warpage. Accordingly, the exposure OL measurement results of the upper wafer UW5 may be worse than when the map correction value MCV3 is not applied. Similarly, the exposure OL measurement results of the upper wafer UW6 may be worse than when the map correction value MCV4 is not applied.

In the bonding process, a bonded wafer BW5 is formed using the upper wafer UW5 and the corresponding lower wafer LW, and a bonded wafer BW6 is formed using the upper wafer UW6 and the corresponding lower wafer LW. The bond OL measurement results for the bonded wafer BW5 may demonstrate that the overlay is favorable with the overlay deviation of the random component being suppressed because the map correction value MCV3 suitable for the amount of warpage of the upper wafer UW5 is used in the exposure process of the bonding surface of the upper wafer UW5. Similarly, the bond OL measurement results for the bonded wafer BW6 may demonstrate that the overlay is favorable with the overlay deviation of the random component being suppressed because the map correction value MCV4 suitable for the amount of warpage of the upper wafer UW6 is used in the exposure process of the bonding surface of the upper wafer UW6.

As described above, the exposure apparatus 1 according to the fourth embodiment can suppress the overlay deviation in the bonding process even though the overlay deviation in the exposure process of the bonding surface of the upper wafer UW may increase. Where the effect on the yield is concerned, in general, the degree of deterioration in the bond OL may be worse than the degree of deterioration in the exposure OL of the bonding surface of the upper wafer UW. In contrast, the exposure apparatus 1 according to the fourth embodiment suitably permits an overlay deviation in a process that allows for a large overlay deviation range (for example, in a preprocess exposure process). Thus, the exposure apparatus 1 according to the fourth embodiment suppresses an overlay deviation in a process that allows for only a small overlay deviation range (for example, in the bonding process). As a result, the exposure apparatus 1 according to the fourth embodiment is capable of improving semiconductor device yield similarly to the first embodiment.

<5> Fifth Embodiment

A semiconductor manufacturing system PS according to a fifth embodiment has a configuration similar to that of the first embodiment. In the fifth embodiment, the overlay deviation of the random component depending on the amount of warpage of an upper wafer UW is corrected using a method similar to that of the second embodiment. Hereinafter, details of the semiconductor manufacturing system PS according to the fifth embodiment will be described.

<5-1> Relationship between amount of warpage of upper wafer UW and polynomial regression coefficient

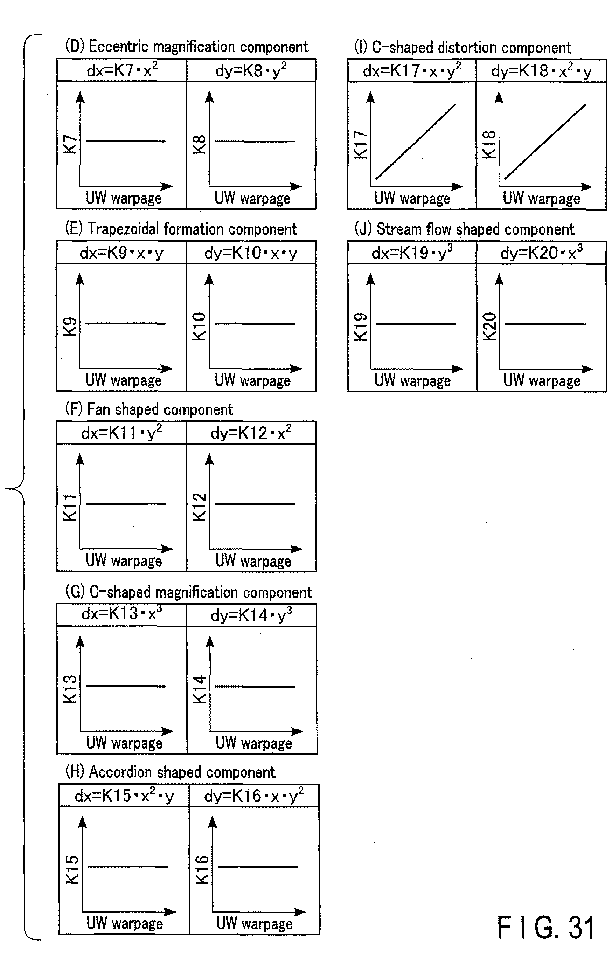

FIG. 31 is a diagram illustrating examples of the relationship between the amount of warpage of an upper wafer UW and the polynomial regression coefficient pertaining to a bonded wafer BW manufactured by a semiconductor manufacturing system PS according to the fifth embodiment. The overlay deviation components illustrated in (D) to (J) of FIG. 31 correspond to the overlay deviation components illustrated in (D) to (J) of FIG. 2, respectively. In the graph illustrated in the frame of each overlay deviation component, the vertical axis represents the polynomial regression coefficients (K values), and the horizontal axis represents the amounts of warpage of the upper wafer UW (UW warpage).

As illustrated in FIG. 31, in this example, none of K7 to K16, K19, and K20 shows a strong sensitivity to the amount of warpage of the upper wafer UW. On the other hand, K17 and K18 show a strong sensitivity to the amount of warpage of the upper wafer UW. That is, in the case of the bonded wafer BW of this example, the overlay deviation amount based on K17 and K18 of the bond OL measurement may change according to the amount of warpage of the upper wafer UW. Therefore, in the semiconductor manufacturing system PS according to the fifth embodiment, a relational expression between the polynomial regression coefficients (for example, K17 and K18) obtained through the bond OL measurement and the amount of warpage of the upper wafer UW is created and used for alignment in the exposure process.

<5-2> Method for manufacturing semiconductor device

Hereinafter, an example of a specific process using the semiconductor manufacturing system PS will be described as a method for manufacturing a semiconductor device according to the fifth embodiment. That is, a semiconductor device is manufactured using the exposure method (exposure process) of the fifth embodiment, which is described hereinbelow.

<5-2-1> Method for creating correction formula

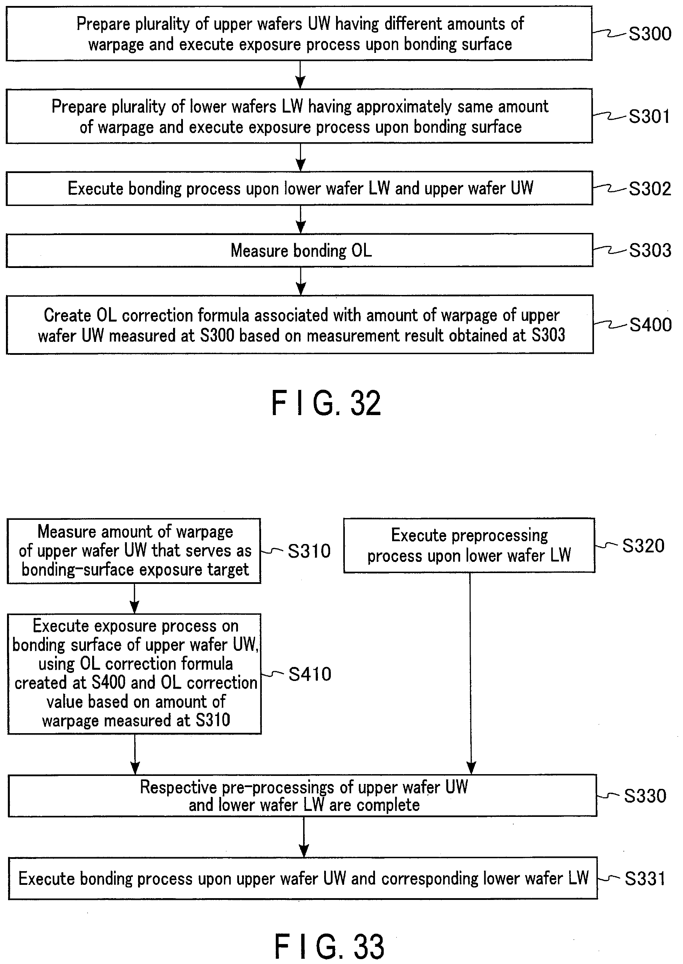

FIG. 32 is a flowchart illustrating an example of a method for creating an OL correction formula used by the exposure apparatus 1 according to the fifth embodiment. An example of a method for creating the OL correction formula will be described with reference to FIG. 32.

First, in the same manner as in the fourth embodiment, the processes of S300 to S303 are executed. That is, a plurality of upper wafers UW having different amounts of warpage are prepared, and an exposure process is executed upon the bonding surfaces of the upper wafers UW (S300). A plurality of lower wafers LW having approximately the same amount of warpage are prepared, and an exposure process is executed upon the bonding surfaces of the lower wafers LW (S301). Thereafter, a bonding process is executed upon a lower wafer LW and an upper wafer UW (S302). Then, a bond OL measurement is performed on each of a plurality of bonded wafers BW formed in the process of S302 (S303).

Next, the server 3 creates an overlay (OL) correction formula by which the amount of warpage of the upper wafer UW and the bond OL measurement results are associated with each other, based on the bond OL measurement results obtained in the process of S303 (S400). The OL correction formula thus created is stored in, for example, the storage device 11 of the exposure apparatus 1. The OL correction formula is a relational expression between the amount of warpage of the upper wafer UW and the predetermined K value. That is, by substituting the measured value for the amount of warpage of the upper wafer UW into the OL correction formula, a correction value for the K value, which can be used for alignment correction by the exposure apparatus 1, can be calculated. The predetermined K value is a parameter dependent upon the amount of warpage of the upper wafer UW, and includes, for example, K17 and K18. The K values used in the OL correction formula are not limited to K17 and K18, and other K values may be used. In the fifth embodiment, it suffices that at least a K value exhibiting sensitivity to the amount of warpage of the upper wafer UW in the bond OL is used in the OL correction formula.

<5-1-2> Process flow from exposure process to bonding process

FIG. 33 is a flowchart illustrating an example of a process related to alignment correction of a random component in the semiconductor manufacturing system PS according to the fifth embodiment. Hereinafter, the process flow from the exposure process to the bonding process of the fifth embodiment will be described below with reference to FIG. 33.

First, the amount of warpage of the upper wafer UW, which is the bonding-surface exposure target, is measured (S310). The data of the amount of warpage of the upper wafer UW is transferred, for example, to the exposure apparatus 1 via the server 3, and stored in the storage device 11 of the exposure apparatus 1.

Next, an exposure process is executed on the bonding surface of the upper wafer UW, using the OL correction formula created in the process of S400 and the OL correction value based on the amount of warpage of the upper wafer UW calculated in the process of S310 (S410). Specifically, the exposure apparatus 1 according to the fifth embodiment first calculates the OL correction values, for example, for K17 and K18 by substituting the value for the amount of warpage of the upper wafer UW into the OL correction formula. Then, in the alignment correction process (S103 in FIG. 9), the OL correction values for K17 and K18, which have been calculated based on the amount of warpage of the upper wafer UW, are reflected by the exposure apparatus 1 on the OL correction value calculated by polynomial regression using the measurement results of at least three alignment marks AM. That is, for K value correction, a K value calculated by substituting the amount of warpage of the upper wafer UW into the OL correction formula is used. For example, the OL correction values, K17 and K18, which have been calculated based on the amount of warpage of the upper wafer UW, are used as offsets of the alignment correction values in the wafer surface.

In parallel with the processes in S310 and S311, a pre-processing is executed upon the lower wafer LW (S320). As a result, a lower wafer LW is formed.

After the respective pre-processings of the upper wafer UW and the lower wafer LW are completed (S330), a bonding process is executed (S331). In this manner, a bonded wafer BW, in which the upper wafer UW and corresponding lower wafer LW are bonded to each other, is formed. The other processes in the exposure apparatus 1 according to the fifth embodiment are similar to those of the fourth embodiment.

<5-2> Advantageous effects of fifth embodiment

In the exposure apparatus 1 according to the fifth embodiment described hereinabove, the overlay deviation in the bonding process can be suppressed, even though the overlay deviation in the upper wafer UW in the exposure process increases, in the same manner as in the fourth embodiment. As a result, the exposure apparatus 1 according to the fifth embodiment is capable of improving semiconductor device yield similarly to the fourth embodiment.

For the creation of the OL correction formula according to the fifth embodiment, a Zernike polynomial may be used as in the modification of the second embodiment. In this example, an OL correction formula is created by using a Zernike coefficient having a high correlation with the amount of warpage of the upper wafer UW. The exposure apparatus 1 calculates a correction value for the Zernike coefficient based on the amount of warpage of the upper wafer UW, and uses this value for the alignment correction process. That is, the exposure apparatus 1 may correct the value of a specific Zernike coefficient for the alignment correction based on the specific correction value of the Zernike coefficient calculated based on the amount of warpage of the upper wafer UW. When a Zernike polynomial is used for creation of an OL correction formula, an overlay deviation can be suppressed in the bonding process in the same manner as in the use of a polynomial regression coefficient.

<6> Others

In the above embodiments, the flowchart used to describe the operations is merely an example. The operations described using the flowchart are interchangeable within a range permitting the order of processing, and further processes may be added, or some processes may be omitted. In the foregoing embodiment, a case where bonding is performed by applying alignment correction to the lower wafer LW placed (held) on the lower stage 230 has been exemplified, but the present invention is not limited thereto. The alignment correction in the bonding process may also be applied to, for example, the upper wafer UW placed (held) on the upper stage 233, or may be applied to both the upper wafer UW held on the upper stage 233 and the lower wafer LW held on the lower stage 230. The fourth embodiment may be combined with any of the first to third embodiments. The fifth embodiment may be combined with any of the first to third embodiments. In this specification, a micro processing unit (MPU), an application specific integrated circuit (ASIC), a field-programmable gate array (FPGA), or the like, may also be used instead of the CPU. Furthermore, each of the processes described in the embodiment may also be realized using dedicated hardware. The processing described in the embodiment may be a mixture of processing executed by software and processing executed by hardware, or only either one of such processing may be used.

The amount of warpage of a wafer may be measured by the exposure apparatus 1, or by an externally provided measurement apparatus. Throughout the present specification, the amount of warpage of a wafer is expressed, for example, by a difference between the heights of the wafer at its peripheral portion and at its central portion. A micrometer ($\mu$m) may be used as a unit of the amount of warpage of the wafer. The amount of warpage of a wafer may be expressed by a signed distance from a three-point reference plane, based on the measurement results of the height of the wafer at the center. The amount of warpage of the wafer may be set, for example, to a positive value if it is above the three-point reference plane and to a negative value if it is below the plane. The amount of warpage of a wafer may be measured through the calculation of the geometry (warpage) of the wafer by measuring the heights at different coordinates of the wafer using, for example, a laser displacement gauge, a confocal displacement gauge, a capacitance formula, a heterodyne interferometer, and a Fizeau interferometer.

In the present specification, a "connection" indicates that two elements are electrically connected, and does not preclude another element being interposed therebetween. "Electrically connected" may signify that an insulator is interposed, as long as operation like that afforded by an electrical connection is possible. "Columnar shape" indicates a structure that is provided in a hole formed in the manufacturing process. The "plan view" corresponds to, for example, viewing an object in a direction perpendicular to the surface of the semiconductor substrate 80. A "region" may be regarded as a configuration that is contained by the semiconductor substrate 80 of the CMOS chip CC. For example, in a case where it is prescribed that the semiconductor substrate 80 includes the memory region MR, the memory region MR is associated with a region above the semiconductor substrate 80. The attachment pads BP may also be referred to as "joint metal". The camera 144 of the exposure apparatus 1 may also be configured by being divided into an optical system (microscope) and a light receiving sensor. Each of the cameras 144, 232, and 235 may be referred to as a "measurement device" as long as same are capable of measuring the alignment marks AM. In the present specification, "overlap deviation" may also be paraphrased as "misalignment".

The configuration described in the third embodiment is merely an example, and the configuration of the memory device 4 is not limited thereto. The circuit configuration, planar layout, and cross-sectional structure of the memory device 4 can be appropriately changed according to the design of the memory device 4. For example, although a case where the memory chip MC is provided on the CMOS chip CC has been given by way of an example in the third embodiment, the CMOS chip CC may also be provided on the memory chip MC. Although a case where the memory chip MC is allocated to the lower wafer LW and the CMOS chip CC is allocated to the upper wafer UW has been given by way of an example, the memory chip MC may be allocated to the upper wafer UW, and the CMOS chip CC may be allocated to the lower wafer LW. When the manufacturing method described in the first and second embodiments is applied, a wafer exhibiting a large variation in wafer magnification between wafers is preferably allocated to the lower wafer LW. Thus, because overlay deviation in the bonding process can be suppressed, the occurrence of defects caused by such overlay deviation can be suppressed.

Some or all of the embodiments described above can be described as in the following supplementary notes, but is not limited thereto:

[Supplementary Note 1]

A method for manufacturing a semiconductor device, comprising:

measuring alignment marks formed on a substrate;
calculating a first alignment correction coefficient from polynomial regression using measurement results of the alignment marks;
correcting a second alignment correction coefficient based on a magnitude of the first alignment correction coefficient or an amount of warpage of the substrate; and
controlling an exposure position relative to the substrate based on the first alignment correction coefficient and the corrected second alignment correction coefficient.

[Supplementary Note 2]

The method according to Supplementary Note 1, wherein
the first alignment correction coefficient corresponds to misalignment of a magnification component.

[Supplementary Note 3]

The method according to Supplementary Note 1, wherein
the second alignment correction coefficient is calculated from the polynomial regression, and is corrected based on the magnitude of the first alignment correction coefficient.

[Supplementary Note 4]

The method according to Supplementary Note 3, wherein

when the exposure position is expressed by a coordinate system using an X direction and a Y direction that intersects the X direction, where an X coordinate is "x", and a Y coordinate is "y",
an alignment correction formula in the X direction includes a sum of $K3 \cdot x$ and $K17 \cdot x \cdot y^2$,
an alignment correction formula in the Y direction includes a sum of $K4 \cdot y$ and $K18 \cdot x^2 \cdot y$,
the K3 and the K4 correspond to the first alignment correction coefficient, and
the K17 and the K18 correspond to the second alignment correction coefficient.

[Supplementary Note 5]

The method according to Supplementary Note 1, wherein
the second alignment correction coefficient is a coefficient of a Zernike polynomial.
While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

**Claims**

1. An exposure apparatus configured to implement an exposure process for exposing a substrate to light, the exposure apparatus comprising:

   a stage configured to hold the substrate;
   a storage device configured to store a plurality of correction maps each having an alignment correction value that differs from each other; and
   a controller configured to control in the exposure process an exposure position relative to the substrate by selecting a correction map from the correction maps based on measurement results of a plurality of alignment marks arranged on the substrate or an amount of warpage of the substrate and moving the stage based on the selected correction map.

2. The exposure apparatus according to claim 1, wherein

the exposure process includes exposure of a plurality of shots with respect to the substrate, and
the correction map includes an alignment correction value for each shot.

3. The exposure apparatus according to claim 1, further comprising:

   a measurement device configured to measure the plurality of alignment marks,
   wherein in the exposure process the controller calculates an alignment correction coefficient of a magnification component in a surface of the substrate based on the measurement result of the alignment marks, and selects the correction map from the correction maps based on a magnitude of the alignment correction coefficient.

4. An exposure apparatus configured to implement an exposure process for exposing a substrate to light, the exposure apparatus comprising:

   a stage configured to hold the substrate;
   a measurement device configured to measure a plurality of alignment marks formed on the substrate; and
   a controller configured to control an exposure position relative to the substrate by moving the stage based on a first alignment correction coefficient and a second alignment correction coefficient,
   wherein in the exposure process the controller calculates the first alignment correction coefficient from polynomial regression using measurement results of the alignment marks, and corrects the second alignment correction coefficient based on a magnitude of the first alignment correction coefficient or an amount of warpage of the substrate.

5. The exposure apparatus according to claim 4, wherein
the first alignment correction coefficient corresponds to misalignment of a magnification component.

6. The exposure apparatus according to claim 4, wherein
the second alignment correction coefficient is calculated from the polynomial regression, and is corrected based on the magnitude of the first alignment correction coefficient.

7. The exposure apparatus according to claim 6, wherein

   when the exposure position is expressed by a coordinate system using an X direction and a Y direction that intersects the X direction, where an X coordinate is "x", and a Y coordinate is "y",

an alignment correction formula in the X direction includes a sum of $K3 \cdot x$ and $K17 \cdot x \cdot y^2$,

an alignment correction formula in the Y direction includes a sum of $K4 \cdot y$ and $K18 \cdot x^2 \cdot y$,

the K3 and the K4 correspond to the first alignment correction coefficient, and

the K17 and the K18 correspond to the second alignment correction coefficient.

8. The exposure apparatus according to claim 4, wherein

the second alignment correction coefficient is a coefficient of a Zernike polynomial.

9. A method for manufacturing a semiconductor device, comprising:

selecting, based on measurement results of a plurality of alignment marks arranged on a substrate or an amount of warpage of the substrate, a correction map from a plurality of correction maps each having an alignment correction value that differs from each other; and

controlling an exposure position relative to the substrate based on the selected correction map.

10. The method according to claim 9, wherein

the correction map includes an alignment correction value for each shot.

11. The method according to claim 9, further comprising:

measuring the alignment marks;

calculating an alignment correction coefficient of a magnification component in the surface of the substrate based on the measurement results of the alignment marks; and

selecting a correction map from the correction maps based on a magnitude of the alignment correction coefficient.

F I G. 1

(A) Offset (shift) component

| $dx=K1$ | $dy=K2$ |
|---|---|

(B) Magnification component

| $dx=K3 \cdot x$ | $dy=K4 \cdot y$ |
|---|---|

(C) Rhombus (orthogonality) component

| $dx=K5 \cdot y$ | $dy=K6 \cdot x$ |
|---|---|

(D) Eccentric magnification component

| $dx=K7 \cdot x^2$ | $dy=K8 \cdot y^2$ |
|---|---|

(E) Trapezoidal component

| $dx=K9 \cdot x \cdot y$ | $dy=K10 \cdot x \cdot y$ |
|---|---|

(F) Fan shaped component

| $dx=K11 \cdot y^2$ | $dy=K12 \cdot x^2$ |
|---|---|

(G) C-shaped magnification component

| $dx=K13 \cdot x^3$ | $dy=K14 \cdot y^3$ |
|---|---|

(H) Accordion shaped component

| $dx=K15 \cdot x^2 \cdot y$ | $dy=K16 \cdot x \cdot y^2$ |
|---|---|

(I) C-shaped distortion component

| $dx=K17 \cdot x \cdot y^2$ | $dy=K18 \cdot x^2 \cdot y$ |
|---|---|

(J) Stream flow shaped component

| $dx=K19 \cdot y^3$ | $dy=K20 \cdot x^3$ |
|---|---|

F I G. 2

(A) During exposure processing

AM

(B) During bonding processing
(upper wafer UW)

AM_C
AM_L
AM_R

(C) During bonding processing
(lower wafer LW)

AM_C
AM_L
AM_R

# F I G. 3

| Overlay deviation component | Exposure apparatus | Bonding apparatus |
|---|---|---|
| Shift component | Correctable | Correctable |
| XY common magnification component | Correctable | Correctable |
| XY differential magnification component | Correctable | Difficult to correct |
| Rotation component | Correctable | Correctable |
| Orthogonality component | Correctable | Difficult to correct |
| Random component | Correctable in shot units | Difficult to correct |

# F I G. 4

PS

3

Server

NW

1

Exposure
apparatus

2

Bonding
apparatus

F I G. 5

1

10

Control device

11

Storage device

110 — Exposure recipe

111 — Correction value
information

112 — Map correction
value set

12

Carrier device

13

Communication device

14

Exposure unit

Light source ~142

RT

141

Projection
optical ~143
system

144

WF

140

F I G. 6

2

20
Control device

21
Carrier device

22
Communication device

23
Bonding unit

234

233
UW

235

232
LW

230

231

F I G. 7

3

30
CPU

31
ROM

32
RAM

Storage device
33

Communication device
34

F I G. 8

```
                    ┌─────────────┐
                    │    Start    │
                    └──────┬──────┘
                           │
                           ▼
        ┌──────────────────────────────────┐
        │           Load wafer             │ ~~ S100
        └──────────────────┬───────────────┘
                           │
                           ▼
        ┌──────────────────────────────────┐
        │      Check exposure recipe 110   │ ~~ S101
        └──────────────────┬───────────────┘
                           │
                           ▼
        ┌──────────────────────────────────┐
        │       Measure alignment marks    │ ~~ S102
        └──────────────────┬───────────────┘
                           │
                           ▼
        ┌──────────────────────────────────┐
        │    Alignment correction processing│ ~~ S103
        └──────────────────┬───────────────┘
                           │
                           ▼
        ┌──────────────────────────────────┐
        │        Exposure sequence         │ ~~ S104
        └──────────────────┬───────────────┘
                           │
                           ▼
        ┌──────────────────────────────────┐
        │ Update correction value information 111 │ ~~ S105
        └──────────────────┬───────────────┘
                           │
                           ▼
        ┌──────────────────────────────────┐
        │          Unload wafer            │ ~~ S106
        └──────────────────┬───────────────┘
                           │
                           ▼
                    ┌─────────────┐
                    │     End     │
                    └─────────────┘
```

# F I G. 9

| (1) Before bonding processing | (5) Rotational alignment (AM_R measurement) |
|---|---|
| 233 234 235 232 231 230 | 233 234 235 232 231 230 |
| (2) Deformation of lower stage 240 | (6) Camera origin alignment |
| 233 234 235 232 231 230 | 233 234 235 236 232 231 230 |
| (3) Wafer loading | (7) Shift alignment (AM_C measurement) |
| 233 234 235 UW LW 232 231 230 | 233 234 235 232 231 230 |
| (4) Rotational alignment (AM_L measurement) | (8) Bonding sequence |
| 233 234 235 232 231 230 | 233 234 235 232 231 230 |

F I G. 10

| Time | Plane | Cross-section |
|------|-------|---------------|
| T1 | | |
| T2 | | |
| T3 | | |
| T4 | | |
| T5 | | |

# F I G. 11

| Prepare plurality of lower wafers LW having different wafer magnifications | ~S110 |

↓

| Prepare plurality of upper wafers UW having fixed wafer magnification | ~S111 |

↓

| Correct wafer magnification to be equal to wafer magnification set in S110, and execute bonding process of lower wafer LW and upper wafer UW | ~S112 |

↓

| Bond OL measurement | ~S113 |

↓

| Create map correction values associated with wafer magnification correction values based on measurement results of S113 | ~S114 |

## F I G. 12

| Execute exposure processing of upper wafer UW | ~S120 |

| Execute exposure processing of lower wafer LW by using map correction values based on wafer magnification correction values | ~S130 |

↓ ↓

| Store, on server 3, correction value information 111a including wafer magnification correction values used in S120 | ~S121 |

| Store, on server 3, correction value information 111b including wafer magnification correction values used in S130 | ~S131 |

↓ ↓

| Respective pre-processings of upper wafer UW and lower wafer LW are complete | ~S140 |

↓

| Calculate wafer magnification correction values in bonding processing based on correction value information 111a and 111b | ~S141 |

↓

| Execute bonding processing by using wafer magnification correction values calculated in S141 | ~S142 |

## F I G. 13

(A)

| | UW | LW1 | LW2 |
|---|---|---|---|
| Exposure OL measurement | (circle) Favorable | Large magnification correction amount — Favorable | Small magnification correction amount — Favorable |
| Bonding OL measurement | Bonding → | BW1 — Worse | BW2 — Worse |

Create map correction value MCV1 based on bond OL measurement results for BW1

(B)

| | UW | LW3 | MCV1 applied | LW4 |
|---|---|---|---|---|
| Exposure OL measurement | (circle) Favorable | Large magnification correction amount — Worse | | Small magnification correction amount — Worse |
| Bonding OL measurement | Bonding → | BW3 — Favorable | | BW4 — Worse |

F I G. 14

F I G. 15

(D) Eccentric magnification component

| $dx=K7 \cdot x^2$ | $dy=K8 \cdot y^2$ |
|---|---|

(E) Trapezoidal formation component

| $dx=K9 \cdot x \cdot y$ | $dy=K10 \cdot x \cdot y$ |
|---|---|

(F) Fan shaped component

| $dx=K11 \cdot y^2$ | $dy=K12 \cdot x^2$ |
|---|---|

(G) C-shaped magnification component

| $dx=K13 \cdot x^3$ | $dy=K14 \cdot y^3$ |
|---|---|

(H) Accordion shaped component

| $dx=K15 \cdot x^2 \cdot y$ | $dy=K16 \cdot x \cdot y^2$ |
|---|---|

(I) C-shaped distortion component

| $dx=K17 \cdot x \cdot y^2$ | $dy=K18 \cdot x^2 \cdot y$ |
|---|---|

(J) Stream flow shaped component

| $dx=K19 \cdot y^3$ | $dy=K20 \cdot x^3$ |
|---|---|

FIG. 16

Prepare plurality of lower wafers LW having different wafer magnifications —— S110

Prepare plurality of upper wafers UW having fixed wafer magnification —— S111

Correct wafer magnification to be equal to wafer magnification set in S110, and execute bonding processing of lower wafer LW and upper wafer UW —— S112

Bond OL measurement —— S113

Create OL correction formula associated with wafer magnification correction values based on measurement results of S113 —— S200

# F I G. 17

Execute exposure processing of upper wafer UW —— S120

Execute exposure processing of lower wafer LW by using OL correction values based on OL correction formula created in S200 and on wafer magnification correction values —— S210

Store, on server 3, correction value information 111a including wafer magnification correction values used in S120 —— S121

Store, on server 3, correction value information 111b including wafer magnification correction values used in S210 —— S211

Respective pre-processings of upper wafer UW and lower wafer LW are complete —— S140

Calculate wafer magnification correction values in bonding processing based on correction value information 111a and 111b —— S141

Execute bonding processing by using wafer magnification correction values calculated in S141 —— S142

# F I G. 18

# F I G. 19

4

Memory device

41

Sequencer

CH

40

Memory I/F

45

Sense amplifier
module

43

Driver module

44

Row decoder module

42

Memory cell array

BLK0

BLK1

⋮

BLKn

F I G. 20

41

F I G. 21

F I G. 22

F I G. 23

F I G. 24

MP

X

Y ← ⊗ Z

62

70

71

73
74 } 72
75

XXV                    XXV

# F I G. 25

F I G. 26

| Prepare plurality of upper wafers UW having different amounts of warpage and execute exposure process upon bonding surface | S300 |

↓

| Prepare plurality of lower wafers LW having approximately same amount of warpage and execute exposure process upon bonding surface | S301 |

↓

| Execute bonding process upon lower wafer LW and upper wafer UW | S302 |

↓

| Measure bonding OL | S303 |

↓

| Create map correction values associated with amount of warpage of upper wafer UW measured at S300 based on measurement result obtained at S303 | S304 |

F I G. 27

| Measure amount of warpage of upper wafer UW that serves as bonding-surface exposure target | S310 |

| Execute preprocessing process upon lower wafer LW | S320 |

↓

| Execute exposure process on bonding surface of upper wafer UW, using map correction value corresponding to amount of warpage measured at S310 | S311 |

↓

| Respective pre-processings of upper wafer UW and lower wafer LW are complete | S330 |

↓

| Execute bonding process upon upper wafer UW and corresponding lower wafer LW | S331 |

F I G. 28

(A)

| Exposure OL measurement | LW | UW1 | UW2 |
|---|---|---|---|
| | Favorable | Large wafer warpage | Small wafer warpage |
| | | Favorable | Favorable |
| | | ↓ BW1 | ↓ BW2 |
| Bonding OL measurement | Bonding ⇒ | Worse | Worse |

⇧ Create map correction value MCV3 based on bonding OL measurement results for BW1

(B)

| Exposure OL measurement | LW | UW3 MCV3 applied UW4 | |
|---|---|---|---|
| | Favorable | Large wafer warpage | Small wafer warpage |
| | | Worse | Worse |
| | | ↓ BW3 | ↓ BW4 |
| Bonding OL measurement | Bonding ⇒ | Favorable | Worse |

F I G. 29

F I G. 30

(D) Eccentric magnification component

| $dx=K7 \cdot x^2$ | $dy=K8 \cdot y^2$ |
|---|---|

(E) Trapezoidal formation component

| $dx=K9 \cdot x \cdot y$ | $dy=K10 \cdot x \cdot y$ |
|---|---|

(F) Fan shaped component

| $dx=K11 \cdot y^2$ | $dy=K12 \cdot x^2$ |
|---|---|

(G) C-shaped magnification component

| $dx=K13 \cdot x^3$ | $dy=K14 \cdot y^3$ |
|---|---|

(H) Accordion shaped component

| $dx=K15 \cdot x^2 \cdot y$ | $dy=K16 \cdot x \cdot y^2$ |
|---|---|

(I) C-shaped distortion component

| $dx=K17 \cdot x \cdot y^2$ | $dy=K18 \cdot x^2 \cdot y$ |
|---|---|

(J) Stream flow shaped component

| $dx=K19 \cdot y^3$ | $dy=K20 \cdot x^3$ |
|---|---|

F I G. 31

```
┌─────────────────────────────────────────────────────────────────┐
│  Prepare plurality of upper wafers UW having different amounts of │ ⌐∿ S300
│  warpage and execute exposure process upon bonding surface        │
└─────────────────────────────────────────────────────────────────┘
                              │
                              ▼
┌─────────────────────────────────────────────────────────────────┐
│  Prepare plurality of lower wafers LW having approximately same   │ ⌐∿ S301
│  amount of warpage and execute exposure process upon bonding      │
│  surface                                                          │
└─────────────────────────────────────────────────────────────────┘
                              │
                              ▼
┌─────────────────────────────────────────────────────────────────┐
│  Execute bonding process upon lower wafer LW and upper wafer UW   │ ⌐∿ S302
└─────────────────────────────────────────────────────────────────┘
                              │
                              ▼
┌─────────────────────────────────────────────────────────────────┐
│                       Measure bonding OL                          │ ⌐∿ S303
└─────────────────────────────────────────────────────────────────┘
                              │
                              ▼
┌─────────────────────────────────────────────────────────────────┐
│  Create OL correction formula associated with amount of warpage   │ ⌐∿ S400
│  of upper wafer UW measured at S300 based on measurement result   │
│  obtained at S303                                                 │
└─────────────────────────────────────────────────────────────────┘
```

## F I G. 32

```
┌────────────────────────┐              ┌────────────────────────┐
│ Measure amount of      │              │  Execute preprocessing │
│ warpage of upper wafer │ ⌐∿ S310      │  process upon lower     │ ⌐∿ S320
│ UW that serves as      │              │  wafer LW               │
│ bonding-surface        │              │                         │
│ exposure target        │              └────────────────────────┘
└────────────────────────┘                          │
            │                                        │
            ▼                                        │
┌────────────────────────┐                          │
│ Execute exposure       │                          │
│ process on bonding     │                          │
│ surface of upper wafer │                          │
│ UW, using OL           │ ⌐∿ S410                   │
│ correction formula     │                          │
│ created at S400 and OL │                          │
│ correction value based │                          │
│ on amount of warpage   │                          │
│ measured at S310       │                          │
└────────────────────────┘                          │
            │                                        │
            ▼                                        ▼
┌─────────────────────────────────────────────────────────────────┐
│  Respective pre-processings of upper wafer UW                     │ ⌐∿ S330
│  and lower wafer LW are complete                                  │
└─────────────────────────────────────────────────────────────────┘
                              │
                              ▼
┌─────────────────────────────────────────────────────────────────┐
│  Execute bonding process upon upper wafer UW and corresponding    │ ⌐∿ S331
│  lower wafer LW                                                   │
└─────────────────────────────────────────────────────────────────┘
```

## F I G. 33

Europäisches
Patentamt
European
Patent Office
Office européen
des brevets

# EUROPEAN SEARCH REPORT

Application Number

EP 22 19 5331

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 1 901 337 A1 (NIKON CORP [JP]) 19 March 2008 (2008-03-19) | 1-3,9-11 | INV. G03F9/00 |
| A | * paragraph [0032] – paragraph [0112] * * figures 1,2,6,7,9 * | 4-8 | |
| X | US 2002/042664 A1 (KIKUCHI TAKAHISA [JP]) 11 April 2002 (2002-04-11) | 4,5 | |
| Y | * paragraph [0121] – paragraph [0238] * | 6-8 | |
| A | * figures 2-4,9 * | 1-3,9-11 | |
| Y | WO 2017/038026 A1 (CANON KK [JP]) 9 March 2017 (2017-03-09) | 6-8 | |
| A | * paragraph [0037] – paragraph [0080] * * figures 2,5 * | 1,4,9 | |

TECHNICAL FIELDS
SEARCHED (IPC)

G03F

The present search report has been drawn up for all claims

| Place of search | Date of completion of the search | Examiner |
|---|---|---|
| Munich | 26 May 2023 | Meixner, Matthias |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 22 19 5331

This annex lists the patent family members relating to the patent documents cited in the above-mentioned European search report.
The members are as contained in the European Patent Office EDP file on
The European Patent Office is in no way liable for these particulars which are merely given for the purpose of information.

26-05-2023

| Patent document cited in search report | | Publication date | Patent family member(s) | | Publication date |
|---|---|---|---|---|---|
| EP 1901337 | A1 | 19-03-2008 | EP  1901337 | A1 | 19-03-2008 |
| | | | JP  5194791 | B2 | 08-05-2013 |
| | | | JP WO2006126569 | A1 | 25-12-2008 |
| | | | KR  20080014973 | A | 15-02-2008 |
| | | | TW  I403854 | B | 01-08-2013 |
| | | | US  2008259297 | A1 | 23-10-2008 |
| | | | WO  2006126569 | A1 | 30-11-2006 |
| US 2002042664 | A1 | 11-04-2002 | KR  20010109212 | A | 08-12-2001 |
| | | | TW  511146 | B | 21-11-2002 |
| | | | US  2002042664 | A1 | 11-04-2002 |
| | | | US  2004126004 | A1 | 01-07-2004 |
| WO 2017038026 | A1 | 09-03-2017 | JP  6732419 | B2 | 29-07-2020 |
| | | | JP  2017050428 | A | 09-03-2017 |
| | | | KR  20180048912 | A | 10-05-2018 |
| | | | WO  2017038026 | A1 | 09-03-2017 |

EPO FORM P0459

For more details about this annex : see Official Journal of the European Patent Office, No. 12/82